# EUROPÄISCHE PATENTSCHRIFT

(11) **EP 2 399 153 B1**
(45) Veröffentlichungstag und Bekanntmachung des Hinweises auf die Patenterteilung: **11.04.2018**
(21) Anmeldenummer: 10704087.5
(22) Anmeldetag: 26.01.2010
(51) Int. Cl.: G02B 6/42, G02B 6/255, G02B 6/30, G02B 6/36, H01S 5/40

(54) **LICHTLEITER ZUR ÜBERTRAGUNG VON STRAHLUNG SOWIE HERSTELLVERFAHREN**
LIGHT GUIDE FOR TRANSMITTING RADIATION AND PRODUCTION METHOD
GUIDE D'ONDES POUR LE TRANSFERT DE RAYONNEMENT AINSI QUE SON PROCÉDÉ DE FABRICATION

(30) Priorität: 18.02.2009 DE 102009009367
(43) Veröffentlichungstag der Anmeldung: 28.12.2011
(73) Patentinhaber: Schott AG, 55122 Mainz (DE)
(72) Erfinder: RUSSERT, Hubertus, 65321 Heidenrod (DE)
(86) Internationale Anmeldenummer: PCT/EP2010/000432
(87) Internationale Veröffentlichungsnummer: WO 2010/094384

(56) Entgegenhaltungen:
- DE-B3-102004 006 932
- US-A1- 2004 234 202

## Beschreibung

Die Erfindung betrifft einen Lichtleiter zur Übertragung von Strahlung, insbesondere der Strahlung eines Hochleistungs-Diodenlasers, sowie ein Verfahren zu dessen Herstellung.

Hochleistungsdiodenlaser setzen sich in der Regel aus einem oder mehreren so genannten Laserbarren zusammen, wobei jeder Laserbarren eine Vielzahl von Emittern mit einer spaltförmigen Lichtauskoppelfläche besitzt, die auf dem Laserbarren entlang des Halbleiterübergangs nebeneinander angeordnet sind. Ein einzelner Emitter weist in Richtung des Halbleiterübergangs, der so genannten fast axis, eine sehr geringe Ausdehnung von nur ca. 1µm und parallel zum Halbleiterübergang, in der so genannten slow axis, eine Ausdehnung von typischerweise 100µm bis 200µm auf. Die emittierte Strahlung weist in der fast axis einen großen Divergenzwinkel von typischerweise 20° bis 30° bezogen auf den Halbwinkel auf, in der slow axis einen deutlich geringeren Divergenzwinkel von typischerweise 5°.

Für die Einkopplung von Halbleiterlasern in Lichtleiter gibt es einen umfangreichen Stand der Technik. Allen Konzepten gemein ist das Ziel, die emittierte Strahlung des Halbleiterlasers mit möglichst geringen Koppelverlusten und unter bestmöglicher Beibehaltung der Strahlqualität in eine oder mehrere Fasern einzukoppeln, wobei die Strahlqualität durch das Produkt aus Strahldurchmesser und Divergenz, das so genannte Strahlparameterprodukt, beschrieben werden kann. Die Strahlqualität beschreibt, wie gut die Strahlung eines Lasers fokussiert werden kann und spielt für die meisten Anwendungen eine entscheidende Rolle. Je höher die Strahlqualität ist, desto kleiner ist das Strahlparameterprodukt und umgekehrt.

Nach grundsätzlichen physikalischen Gesetzen kann das Strahlparameterprodukt niemals verringert werden, auch nicht durch optische Elemente oder andere Mittel. Die Strahlqualität kann dementsprechend nicht verbessert werden. Insbesondere bei der Strahlführung und -formung mit nichtabbildenden optischen Elementen kann die Strahlqualität jedoch verringert werden. Aufgrund der spaltförmigen Form der Emitter sowie der unterschiedlichen Strahldivergenzen in der slow und fast axis stellt die Einkopplung der emittierten Strahlung in optische Fasern unter bestmöglicher Beibehaltung der Strahlqualität eine anspruchsvolle Aufgabe dar, zumal optische Fasern in der Regel eine runde Querschnittsform aufweisen.

Bei der Einkopplung der divergenten Strahlung eines Halbleiterlasers in optische Fasern ist ein Fasertyp mit einer ausreichend großen Numerischen Apertur (NA) zu wählen, welcher die gesamte Strahlung aufnehmen kann. Dabei gibt die NA den Sinus des maximalen Halbwinkels eines Lichtstrahls relativ zur Faserachse an, der von der Faser noch übertragen wird. Der Halbwinkel der Laserstrahlung in der fast axis von 20-30° entspricht einer NA von 0.34 bis 0.5, der Halbwinkel der slow axis entspricht einer NA von 0.09.

Bei der Einkopplung der Laserstrahlung in optische Fasern, welche eine geringere NA als diejenige der Laserstrahlung in der fast axis aufweisen - z.B. in eine Standardquarzfaser mit einer NA von 0.22 - ist vor der Einkopplung eine Kollimation der Laserstrahlung in der fast axis erforderlich, was z.B. durch die Einführung von Mikrooptiken, insbesondere Zylinderlinsen, oder auch durch nichtabbildende Optiken wie z.B. Lichtleitstäbe mit sich in Ausbreitungsrichtung des Lichtes aufweitendem Querschnitts wie z.B. kegelförmigem Querschnitt erfolgen kann. Erfolgt keine Kollimation der Strahlung in der fast axis, wird nur der Anteil der Laserstrahlung innerhalb der NA der Faser geführt. Der unter größeren A-perturwinkeln in die Faser eingekoppelte Anteil der Laserstrahlung koppelt aus der Faser aus und kann zu thermischen Beschädigungen und damit zur Zerstörung des opt. Einkoppelendes führen.

Alternativ können auch Fasern mit ausreichend hoher NA verwendet werden, welche die gesamte Laserstrahlung aufnehmen können. Hierbei wird die große Divergenz des Halbleiterlasers in Kauf genommen. Vorteilhaft an dieser Lösung ist, dass in diesem Fall auf eine aufwendige Mikrooptik und deren Positionierung verzichtet werden kann und die Fasern direkt an den Emitter angekoppelt werden können. In diesem Fall wird auch von stumpfer Kopplung gesprochen. Eine entsprechende Ausführung findet sich z.B. in der DE 102005057617 A1, wobei sich diese Lösung ferner dadurch auszeichnet, dass jedem Emitter eine Vielzahl von Fasern zugeordnet ist. Neben der stumpfen Kopplung zeichnet sich diese Ausführung auch dadurch aus, dass die Strahlung in ein verschmolzenes Faserbündel eingekoppelt wird, d.h. die opt. Fasern sind in der Einkoppelfläche formschlüssig miteinander verbunden. Durch die Verschmelzung der Fasern wird zum einen die Koppeleffizienz erhöht, da die Flächenanteile der Faserzwischenräume zwischen den Fasern entfallen, zum anderen wird die Verwendung von Klebstoffen im Bereich der Einkoppelfläche vermieden, die sich aufgrund der hohen Leistungsdichten eines Hochleistungs-Halbleiterlasers verbietet.

Um die Strahlqualität nicht unnötig zu verringern, ist ferner wichtig, dass der Laserstrahl mit möglichst geringem Strahldurchmesser geführt wird, d.h. in einen Lichtleiter mit möglichst geringer lichtleitender Querschnittsfläche eingekoppelt wird. Es findet sich zum Beispiel in der US 4,763,975 ein Konzept, in dem vor dem gesamten Laserbarren mit mehreren Emittern ein einziges Koppelelement positioniert wird, welches eine längliche ovale Lichteinkoppelfläche und eine runde Auskoppelfläche besitzt. Bei diesem Konzept wird die Querschnittsfläche des Laserstrahls deutlich und irreversibel vergrößert, da es sich um eine nichtabbildende Optik handelt. Damit wird also die Strahlqualität stark reduziert. Ferner finden sich Konzepte, in dem jedem Emitter eine Einzelfaser mit rundem Querschnittsprofil zugeordnet wird. Da der Faserdurchmesser in diesem Fall entsprechend der Emitterbreite relativ groß gewählt werden muss, zeichnet sich auch dieses Konzeptes durch eine starke Vergrößerung der aufsummierten Faserquerschnittsfläche relativ zu der Querschnittsfläche aller Emitter und damit ebenfalls durch eine Verringerung der Strahlqualität aus. In einer weiteren bzgl. der Querschnittsfläche verbesserten Ausführungsform ist jedem Emitter eine rechteckige Einzelfaser zugeordnet (US 5,629,997). In diesem Fall der rechteckigen Einzelfasern stellt aber die Verfügbarkeit der rechteckigen Fasern mit ausreichend großer NA ein Problem dar, ferner ist die Positionierung der Einzelfasern vor den Emittern mit sehr großem Aufwand verbunden.

Eine weitere Variante in der DE 102004006932 B3 sieht vor, Einzelfasern mit rundem Querschnitt in einer Monolage bündig nebeneinander anzuordnen und die Monolage in einem Heißpressverfahren in einen Rechteckquerschnitt zu verschmelzen, wobei die Einzelfasern der Monolage einen rechteckigen Querschnitt annehmen. Anschließend wird mit einem Schleifwerkzeug an das freie Ende der verschmolzenen Fasern in einem Schleifprozess ein optisches Element angeformt, im Beispiel eine intrinsische aus dem Stand der Technik bekannte Zylinderlinse oder auch ein Kegel. Beide Elemente erfüllen dabei die Funktion einer Winkelkollimation in der fast axis. Der Einzelfaserdurchmesser ist dabei so gewählt, dass bei der stumpfen Kopplung jedem Emitter des Barrens eine Vielzahl von deformierten Einzelfasern zugeordnet ist.

Das gemäß dem in der DE 102004006932 B3 beschriebene Einkoppelende sowie insbesondere dessen Herstellung weist aber eine Vielzahl von Nachteilen und Bedenken bzgl. der Umsetzbarkeit auf. Erfahrungsgemäß führt die Verformung von optischen Fasern in direktem Kontakt mit einem Presswerkzeug zu großen Problemen. Bei Verwendung eines Presswerkzeugs ohne besondere Qualität der Oberfläche werden die Fasern durch eine Deformation der optischen Grenzfläche gewöhnlich so stark geschädigt, dass die Lichtleitung extrem eingeschränkt ist und ein Großteil der Laserstrahlung aus den Fasern auskoppeln würde. Weiterhin ist dem Fachmann bekannt, dass Anhaftungen oder sogar Anglasungen der optischen Fasern an dem Presswerkzeug zu erwarten sind, wobei der Offenbarung keine Mittel zum Verhindern dieser Effekte zu entnehmen sind. Weiterhin weisen optische Fasern nach einem thermischen Umformprozess eine stark reduzierte mechanische Festigkeit auf, daher ist die Anwendung eines Schleifverfahrens auf das einlagig verschmolzene Faserband, wie es in der Offenbarung beschrieben ist, sowie ein notwendiger Polierprozess nicht möglich, ohne dass Bruch auftritt. Es kann daher davon ausgegangen werden, dass das in dieser Schrift beschriebene Bauteil in der beschriebenen Weise nicht bzw. nicht wirtschaftlich hergestellt werden kann.

Aufgabe der Erfindung ist daher die Bereitstellung eines Lichtleiters insbesondere für die Einkopplung der Strahlung von Hochleistungs-Diodenlasern, mit einer möglichst kleinen, spaltförmigen Einkoppelfläche, welche von verschmolzenen Fasern nahezu vollständig ausgefüllt ist, wobei das Einkoppelende eine für den gesamten Herstellungsprozess ausreichende Stabilität aufweisen soll. Aufgabe der Erfindung ist ferner die Bereitstellung eines geeigneten Verfahrens zur Herstellung des entsprechenden Lichtleiters, wobei insbesondere auch die Verschmelzung einer Monolage von Fasern mit möglichst geringer Schädigung der Fasern sowie Beeinflussung ihrer lichtübertragenden Eigenschaften möglich sein soll.

Die Aufgabe wird durch die unabhängigen Ansprüche gelöst. Bevorzugte Ausführungsformen ergeben sich aus den abhängigen Ansprüchen.

Die Aufgabe der Erfindung wird gelöst durch einen Lichtleiter beinhaltend eine Mehrzahl optischer Fasern mit einem Einkoppelende und einem oder mehreren Auskoppelenden, wobei das Einkoppelende eine Verschmelzzone aufweist, in welcher die Fasern zumindest teilweise formschlüssig untereinander verbunden sind, daran anschließend eine Übergangszone, in welcher der Querschnitt der optischen Fasern von einer im wesentlichen mehreckigen Form in eine im Wesentlichen kreisförmige Form übergeht, und daran anschließend eine Auslaufzone, in welcher die Fasern eine im Wesentlichen kreisförmige Querschnittsform aufweisen, dadurch gekennzeichnet, dass die Fasern in einer Monolage oder auch mehreren Lagen auf einer Trägerplatte angeordnet sind und die Fasern der untersten Lage im Bereich der Verschmelzzone formschlüssig mit der Trägerplatte verbunden sind. Zum einen wird durch die Anordnung der Fasern auf der planen Trägerplatte eine spaltförmige Querschnittsfläche des Einkoppelendes erreicht. Zum anderen wird durch die Anordnung der Fasern auf der Trägerplatte, mit welcher die Fasern formschlüssig verbunden sind, eine ausreichende mechanische Stabilität des Einkoppelendes erreicht, welches eine entsprechende Endflächenbearbeitung des Einkoppelendes ermöglicht. Unter einer formschlüssigen Verbindung ist dabei genauer zu verstehen, dass die Fasern untereinander und mit der Trägerplatte flächig verbunden sind, und dass vor dem Umformprozess vorhandene luftgefüllte Zwischenräume zwischen den Fasern, auch als Zwickel bezeichnet, nach dem Umformprozess nur noch in einem sehr geringen relativen Anteil von weniger als 5% bezogen auf den formschlüssig verbundenen Querschnittsbereich vorhanden sind. Die formschlüssige Verbindung kann außerdem auch stoffschlüssig sein, wobei dann von einer Verschmelzung der Fasern gesprochen werden kann. Im Allgemeinen liefert jedoch für den erfindungsgemäßen Lichtleiter eine formschlüssige Verbindung der Fasern eine für die nachfolgenden Prozessschritte ausreichende Stabilität. Zu diesen Prozessschritten gehört in der Regel eine Endflächenbearbeitung. Die Endflächenbearbeitung umfasst in der Regel Schleif- & Polierprozesse, welche eine hohe mechanische Belastung der Fasern darstellen und deswegen eine entsprechende Stabilität voraussetzen, damit es nicht zu Ausmuschelungen und Ausbrüchen an den Stirnflächen der Fasern kommt. Die mechanische Stabilität der Fasern im Bereich des verformten, unrunden Faserquerschnittes ist in der Regel gering, da die optischen Fasern durch ein Heißpressverfahren, wie es für die Herstellung des erfindungsgemäßen Lichtleiters bevorzugt eingesetzt wird, extrem reduziert wird. So verlieren die Einzelfasern im Heißpressverfahren ihre Vorspannung, die sie aus dem Faserziehprozess der Faser aufgrund der extrem schnellen Abkühlung mitbringen. Ferner werden zahlreiche Mikrorisse und Mikroschädigungen in die Faseroberfläche eingebracht, so dass die verformte Faser im Gegensatz zur gezogenen Fasern sehr spröde ist und bei geringen mechanischen Belastungen bricht. Es muss daher jede mechanische Belastung der verformten Fasern vermieden werden, was in der vorliegenden Erfindung durch die formschlüssige Verbindung mit der Trägerplatte erreicht wird.

Die Fasern weisen in dem nichtverformten Bereich eine im Wesentlichen runde Querschnittsform auf. Produktionsbedingt können jedoch Abweichungen von der runden Querschnittsform, wie z.B. eine Ovalität jedoch vorhanden sein. In der Verschmelzzone weisen die Einzelfasern hingegen in den Bereichen, in denen die Fasern formschlüssig verbunden sind, eine im Wesentlichen mehreckige Querschnittform auf. So können die Fasern bei einer einlagigen Anordnung in der Verschmelzzone bevorzugt vierseitige, rechteckige Querschnitte mit verrundeten Ecken aus, die annähernd Rechteckform aufweisen. Bei mehrlagigen Faserbändern bilden sich hingegen in der Verschmelzzone bevorzugt 6- und 5-seitige Querschnittsformen aus. Die Verbindung der Fasern untereinander ist im Allgemeinen formschlüssig, jedoch nicht unbedingt material- bzw. stoffschlüssig. Das heißt die Fasern sind im Allgemeinen nicht fest miteinander verschmolzen, bilden jedoch ein fest zusammenhaftendes und auf der Trägerplatte haftendes Gebilde.

Die Trägerplatte muss nicht zwangsweise plattenförmig sein. Wesentlich ist mindestens eine Oberfläche mit einem planen Bereich, welcher mit den Fasern formschlüssig verbunden wird. Im Allgemeinen ist unter einer Trägerplatte daher auch ein beliebig geformtes Trägerelement mit zumindest einem planen Flächenabschnitt zu verstehen.

In einer bevorzugten Ausführungsform handelt es sich bei den optischen Fasern um Stufenindex-Multimode-Glasfasern mit einem einheitlichen Faserdurchmesser D, wobei das Verhältnis der Mantelstärke der optischen Fasern zur beabsichtigten Anwendungswellenlänge kleiner als 5, besonders bevorzugt zwischen 0,5 und 3 beträgt. Der erfindungsgemäße Lichtleiter kann prinzipiell mit einer Vielzahl optischer Fasertypen hergestellt werden. So ist die Verwendung von Quarzfasern in Verbindung mit einem geeigneten Material der Trägerplatte denkbar, sowie auch die Verwendung von Kunststofffasern, wobei es sich um Fasern vom Monomode oder Multimode-Typ handeln kann. Bevorzugt werden Stufenindex-Multimode-Glasfasern bestehend aus mindestens zwei Mehrkomponentengläsern eingesetzt, im Allgemeinen umfassend ein Kernglas mit einem Brechwert n_{K} und ein Mantelglas mit einem geringeren Brechwert n_{M}, jeweils bezogen auf die Anwendungswellenlänge. Mit diesen Fasertypen lassen sich hohe Temperaturbeständigkeiten von ca. 300°C - 400°C erreichen sowie auch die erforderlichen Numerische Aperturen für eine stumpfe Ankopplung eines Halbleiterlasers. Des Weiteren werden bevorzugt Stufenindex-Multimode-Glasfasern mit einem möglichst großen Kern-Mantel-Verhältnis eingesetzt, d.h. einem maximalen Flächenanteil des optischen Kerns und einem minimalen Flächenanteil des optischen Mantels bezogen auf die Faserquerschnittsfläche. Das Verhältnis der Dicke des optischen Mantels, auch als Mantelstärke bezeichnet, zur beabsichtigten Anwendungswellenlänge wird dabei bevorzugt kleiner als 5, besonders bevorzugt zwischen 0,5 und 3 gewählt. Dadurch werden die Mantelflächen-Anteile auf der Einkoppelfläche des Lichtleiters und damit die optischen Einkoppelverluste möglichst gering gehalten. Ebenso wird die Gefahr einer thermischen Schädigung des Einkoppelendes gering gehalten. Bei einer Mantelstärke unterhalb der halben Lichtwellenlänge werden die optischen Verluste durch den Mantel hingegen so groß, dass ein nicht vernachlässigbarer Anteil der Strahlung die Faser durch den Mantel verlassen kann (optisches Tunneln), was ebenfalls zu einer thermischen Schädigung des Lichtleiters führen kann. Der erfindungsgemäß bevorzugte Faserdurchmesser liegt im Bereich 30µm bis 100µm, es ist aber auch die Verwendung von Fasern mit größerem oder kleinerem Faserdurchmesser möglich. Es werden bevorzugt Fasern mit einheitlichem Faserdurchmesser eingesetzt. Einheitlicher Faserdurchmesser ist dabei so zu verstehen ist, dass die Abweichungen der Faserdurchmesser der Einzelfasern sich im Wesentlichen innerhalb üblicher unvermeidbarer Fertigungstoleranzen bewegen, die typischerweise 10% des Faserdurchmessers D nicht übersteigen.

In einer bevorzugten Ausführungsform ist die lineare thermische Ausdehnung im Temperaturbereich 20°C bis 300°C der Trägerplatte maximal 3·10⁻⁶/K kleiner, vorzugsweise jedoch größer als diejenige des Mantelglases der optischen Fasern. Die Trägerplatte auf welcher die Fasern verpresst werden, spielt eine zentrale Rolle. Da die Fasern formschlüssig mit der Trägerplatte verbunden sind, muss die thermische Ausdehnung der Trägerplatte an jene der Fasern angepasst sein. Insbesondere darf es durch die unterschiedliche thermische Ausdehnung von Fasern und Trägerplatte nicht zur Bildung von mechanischen Zugspannungen in dem verpressten Faserbündel kommen, welche Faserbruch zur Folge haben können. Die stabilsten Verschmelzungen werden erhalten, wenn die thermischen Ausdehnungen von Trägerplatte, Mantelglas und Kernglas relativ ähnlich sind, d.h. um maximal 2·10⁻⁶/K voneinander abweichen. Ebenso ergeben sich stabile Verschmelzungen, wenn lediglich die thermische Ausdehnung des Mantelglases der Fasern deutlich geringer ist, als die der Trägerplatte, da bei dieser Konfiguration lediglich Druckspannungen in der Faseroberfläche, also im Mantelglas entstehen, welche keinen Faserbruch verursachen. Unerwünscht ist jedoch der Fall, in dem die thermische Ausdehnung des Mantelglases diejenige der Trägerplatte deutlich überschreitet, da sich dann Zugspannungen in den Fasern bilden können. Nach Versuchen mit verschiedenen Fasertypen und Trägerplatten erfordert eine stabile Verschmelzung, dass die thermische Ausdehnung im Temperaturbereich 20°C bis 300°C der Trägerplatte maximal 3.10⁻⁶/K kleiner, vorzugsweise jedoch größer als diejenige des Mantelglases der optischen Fasern ist. Durch diese Bedingung werden kritische Zugspannungen an der Oberfläche der optischen Fasern, die formschlüssig mit der Trägerplatte verbunden sind, vermieden. Entsprechende Bedingungen gelten bei Vorhandensein einer Deckplatte auch für diese.

In einer bevorzugten Ausführungsform sind die Fasern im Bereich der Auslaufzone und/oder der Übergangszone durch geeignete Mittel relativ zur Trägerplatte fixiert, vorzugsweise durch einen Klebstoff. Durch die Fixierung der Fasern relativ zu der Trägerplatte in der Auslauf- und/oder der Übergangszone zusätzlich zu der formschlüssigen Verbindung in der Verschmelzzone wird eine mechanische Belastung der Fasern im Einkoppelende und damit eine Schädigung sicher ausgeschlossen. Erfindungsgemäß weist die den Fasern zugewandte Oberfläche der Trägerplatte eine mittlere Rautiefe R_{z}<1µm besonders bevorzugt R_{z}<0,2µm auf. Da die Trägerplatte und falls vorhanden die Deckplatte in dem Heißpressverfahren formschlüssig mit einem Teil der Fasern verbunden werden, übertragen sich deren Oberflächen auf die optischen Grenzflächen der Faser, d.h. auf die Grenzfläche von Kern- und Mantelglas. Weisen Trägerplatte oder Deckplatte eine Rauhigkeit oder eine Welligkeit auf, so wird die optische Grenzfläche im Allgemeinen derart verformt, dass die lichtleitenden Eigenschaften der Fasern stark verschlechtert werden. Die Träger- und Deckplatte weisen daher bevorzugt auf den Seiten, die den Fasern zugewandt sind, eine ebene und polierte Oberfläche auf. Dafür muss der Wert der mittleren Rautiefe R_{z} gemäß DIN EN ISO 4287:1998 kleiner als 1µm bevorzugt kleiner als 0,2µm sein. Eine entsprechende Oberflächenqualität kann z.B. für metallische Werkstoffe der Trägerplatte durch Schleif- und Polierprozesse erzeugt werden, im Fall von Halbleiterwerkstoffen wie Silizium sind z.B. auch Ätzprozesse möglich. Der Einsatz solcher Halbleiterwerkstoffe als Trägerplatte ist auch vorstellbar und von der Erfindung umfasst. In einer bevorzugten Ausführungsform der Erfindung wird jedoch eine Glasplatte, insbesondere eine Floatglasplatte eingesetzt, welche sowohl die Anforderungen an die thermische Ausdehnung als auch an die hohe Oberflächenqualität erfüllt.

In einer weiteren bevorzugten Ausführungsform besteht die Trägerplatte aus einem Glastyp, dessen Erweichungstemperatur E_{W} über dem höchsten E_{W} der in den optischen Fasern verwendeten Glastypen, vorzugsweise mindestens 50 K über der höchsten Erweichungstemperatur E_{W} der in den optischen Fasern verwendeten Glastypen liegt. Die Fasern sollen sich bei dem bevorzugt eingesetzten Heißpressverfahren nicht in die Trägerplatte abformen, um eine möglichst exakt spaltförmige Einkoppeloberfläche auszubilden. Da das Heißpressverfahren etwa bei einer Temperatur durchgeführt wird, welche der Erweichungstemperatur der in den optischen Fasern verwendeten Glastypen entspricht, muss die Erweichungstemperatur des Glastyps der Trägerplatte also über der Erweichungstemperatur E_{W} der in den optischen Fasern verwendeten Glastypen liegen, bevorzugt mindestens 50 K. Diese Forderung kann durch auf dem Markt verfügbare Floatgläser ebenfalls sichergestellt werden. Falls es sich bei den Fasern um Quarzfasern handelt, kann als Material der Trägerplatte bevorzugt ebenfalls Quarzglas eingesetzt werden, da keine geeigneten Glastypen mit einer entsprechend höheren Erweichungstemperatur verfügbar sind.

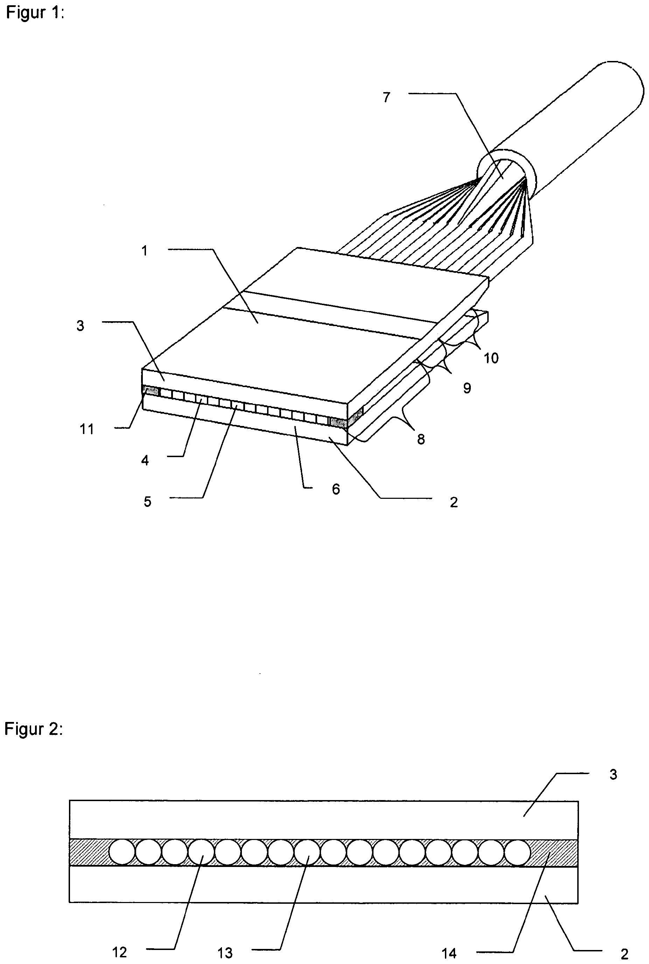

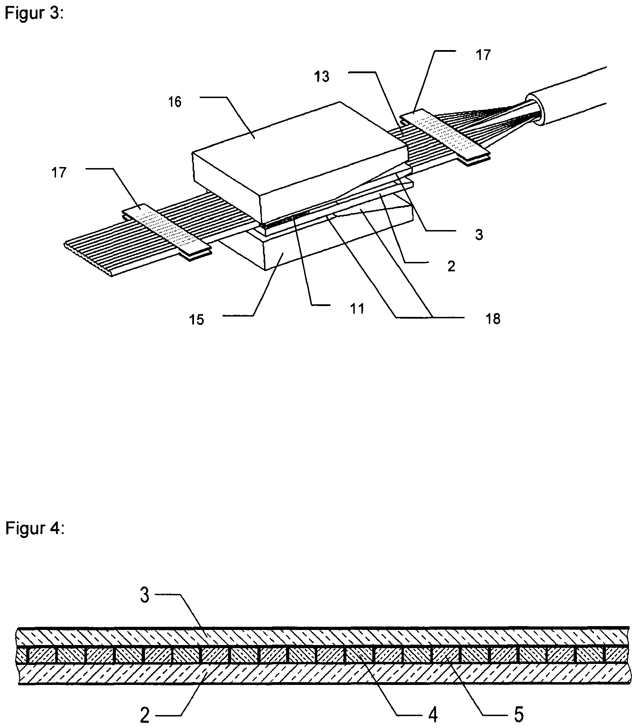

In einer bevorzugten Ausführungsform sind die optischen Fasern im Bereich der Übergangszone und Verschmelzzone einlagig, parallel und bündig angeordnet, und weisen im Bereich der Verschmelzzone einen annähernd rechteckigen Querschnitt auf, sind dort außerdem formschlüssig angeordnet und bilden gemeinsam eine spaltförmige Einkoppelfläche aus, deren Höhe zwischen 60% und 90% des Faserdurchmessers D beträgt. Diese Ausführungsform ist in Figur 1 sowie in Figur 4 schematisch dargestellt. Die Ausführungsform ergibt sich aus der Umformung des einlagig, parallel und bündig angeordneten Faserbandes unter der Randbedingung gemäß dem Unteranspruch 9. In dieser Ausführungsform ist die Höhe der spaltförmigen Einkoppelfläche bereits durch den Faserdurchmesser vorgegeben, und liegt theoretisch bei 78,5% des Faserdurchmessers. In der Praxis können durch Faserdurchmessertoleranzen, Über- oder Unterkompression des Faserbündels auch größere oder geringere Höhen der Einkoppelfläche erreicht werden. Diese Ausführungsform stellt im Vergleich zu den folgenden weiteren Ausführungsformen die bevorzugte Variante dar, da sie fertigungstechnisch am einfachsten zu realisieren ist.

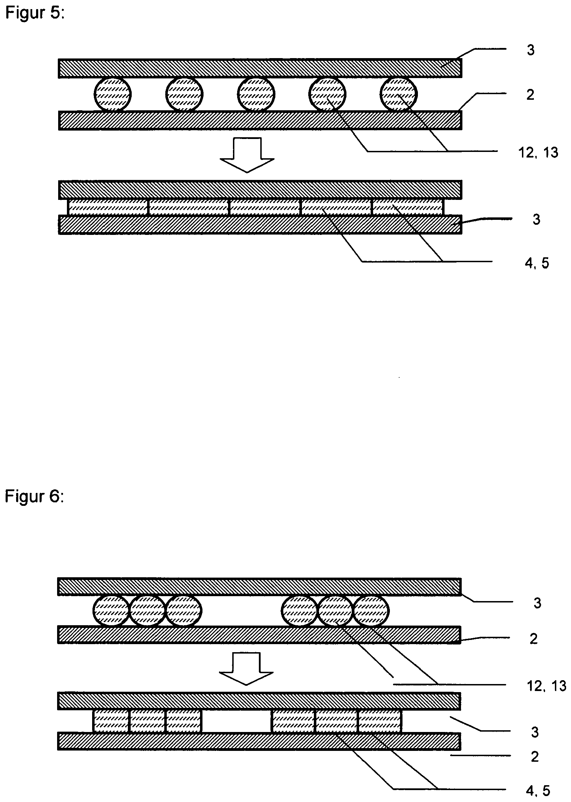

Eine weiteren bevorzugte Ausführungsform ist dadurch gekennzeichnet, dass die optischen Fasern im Übergangsbereich von Auslaufzone und Übergangszone einlagig, parallel und in gleichmäßigen Abständen parallel angeordnet sind, wobei zwei Fasern jeweils einen Abstand von 0 bis zum 5-fachen des Faserdurchmessers D aufweisen, und im Bereich der Verschmelzzone formschlüssig angeordnet sind und gemeinsam eine spaltförmige Einkoppelfläche ausbilden, deren Höhe zwischen 15% und 90% des Faserdurchmessers D beträgt. Diese Ausführungsform ist in Figur 5 in der unteren Teilabbildung schematisch dargestellt. Diese Ausführungsform ermöglicht bei vorgegebenem Faserdurchmesser eine geringere Höhe der Einkoppeloberfläche, da die Einzelfasern erst nach deutlich stärkerer Verformung an die Nachbarfasern stoßen. Fertigungstechnisch erfordert diese Variante allerdings einen höheren Aufwand, da die Fasern vor der Verschmelzung exakt positioniert werden müssen.

Eine weitere bevorzugte Ausführungsform ist dadurch gekennzeichnet, dass nach Ankopplung des Lichtleiters an einen Laserdiodenbarren mit mehreren Emittern und nicht-emittierenden Bereichen zwischen den Emittern nur die Fasern, in welche Laserstrahlung eingekoppelt wird, in einem Auskoppelende zusammengefasst sind und Fasern, in welche keine Laserleistung eingekoppelt wird, keinem Auskoppelende zugeführt sind. Bevorzugt wird der erfindungsgemäße Lichtleiter an einen Halbleiterlaser mit mehreren Emittern angekoppelt, wobei die spaltförmige Einkoppelfläche des Lichtleiters stumpf oder aber über optische Elemente an die Emitterzeile gekoppelt wird. Abhängig von Emitterbreite, Emitterabstand, Faserdurchmesser und Höhe der Einkoppelfläche werden dabei einem Emitter und auch dem nicht-emittierenden Bereich zwischen zwei Emittern ein oder mehrere Fasern auf der Einkoppelfläche zugeordnet. Die Fasern, in welche keine Laserleistung eingekoppelt wird, können nach Ankopplung des Halbleiterlasers und dauerhafter Fixierung von Einkoppelende und Halbleiterlaser identifiziert werden und aus dem Faserbündel herausgeführt und/oder durchtrennt werden. Dadurch wird die Gesamtquerschnittsfläche des Faserbündels auf der Auskoppelseite reduziert und die Strahlqualität entsprechend optimiert.

Eine weitere bevorzugte Ausführungsform ist dadurch gekennzeichnet, dass die optischen Fasern im Übergangsbereich von Auslaufzone und Übergangszone einlagig, parallel und in Gruppen von jeweils 1 bis 5 Fasern angeordnet sind, und im Bereich der Verschmelzzone die Fasern jeweils einer Gruppe formschlüssig angeordnet sind, wobei bei der späteren Kopplung des Lichtleiters mit einem Laserdiodenbarren einem Emitter jeweils eine Gruppe von Fasern zugeordnet ist und wobei in den Bereichen der Einkoppelfläche, die bei der späteren Kopplung des Lichtleiters mit einem Laserdiodenbarren der Fläche zwischen zwei Emittern zugeordnet sind, keine Fasern angeordnet sind. Diese Ausführungsform ist in Figur 6 in der unteren Teilabbildung schematisch dargestellt. Bei dieser Ausführungsform entfällt das in der vorausgehenden Ausführungsform dargestellte Entfernen von Fasern aus dem Bündel, in welche nach Ankopplung an einen Halbleiterlaser keine Strahlung eingekoppelt werden muss. Allerdings müssen die Gruppen von Fasern exakt in dem Emitterabstand angeordnet sein.

Eine weitere bevorzugte Ausführungsform ist dadurch gekennzeichnet, dass die Einkoppelfläche formschlüssig mit den optischen Fasern ausgefüllt ist und die aufsummierte Querschnittsfläche der Einzelfasern in der Verschmelzzone im wesentlichen der aufsummierten Querschnittsfläche der Einzelfasern in der Auslaufzone entspricht oder maximal 25% kleiner als diese ist. Diese bevorzugte Ausführungsform beinhaltet, dass die optischen Fasern in dem Heißpressverfahren weder zu gering noch zu stark komprimiert sind. Die bevorzugte Ausführungsform kann auch so interpretiert werden, dass durch das Heißpressverfahren gerade die vor dem Heißpressen vorhandenen luftgefüllten Zwischenräume zwischen den Fasern eliminiert werden, darüber hinaus aber keine weitere Kompression mehr durchgeführt wird. Es erfolgt also weder eine Unterkompression noch eine Überkompression.

Ist die Querschnittsfläche im Fall der Unterkompression nicht formschlüssig mit den optischen Fasern aufgefüllt, ergeben sich Einkoppelverluste durch Einkopplung von Strahlung in die Faserzwischenräume. Außerdem weist das Einkoppelende eine geringere mechanische Stabilität auf. Bei einer stärkeren Kompression des Bündelquerschnitts im Fall der Überkompression kann es hingegen zu einer starken Beeinträchtigung der lichtleitenden Eigenschaften des Faserbandes kommen, da es aufgrund eines dann einsetzenden Materialflusses in Richtung der Faserachse während der Verschmelzung zu einer Aufstauchung der Faser in axialer Richtung kommen kann. Durch die Aufstauchung der Faser kann auch deren optische Grenzfläche verformt werden, was die beschriebene Beeinträchtigung der lichtleitenden Eigenschaften bedeutet. Es kann jedoch im Einzelfall und in Abhängigkeit der Materialkombination vorteilhaft sein, wenn die Gesamtquerschnittsfläche der Einzelfasern in der Verschmelzzone die Gesamtquerschnittsfläche der Einzelfasern im unverschmolzenen Faserbündel leicht oder maximal um 25% unterschreitet, also eine leichte Überkompression erfolgt. Dadurch können z.B. Schwankungen der Einzelfaserdurchmesser kompensiert werden oder die formschlüssige Verbindung bzw. Verschmelzung verbessert werden.

Eine weitere bevorzugte Ausführungsform ist dadurch gekennzeichnet, dass die Fasern in der Verschmelzzone an ihrer Oberseite mit einer Deckplatte formschlüssig verbunden sind. In einer bevorzugten Ausführungsform der Erfindung werden die Fasern zumindest in dem für die Verschmelzzone vorgesehenen Bereich vor dem Heißpressen mit einer Deckplatte zugedeckt, so dass nach dem Heißpressen ein dreischichtiger Aufbau bestehend aus Trägerplatte, einer oder mehrerer Faserlagen und Deckplatte entsteht. Die Höhe der Einkoppelfläche entspricht dann dem Abstand von Träger- und Deckplatte. Eine Deckplatte erfüllt nach dem Heißpressverfahren die Aufgabe einer weiteren Stabilisierung des Einkoppelendes. Ferner wird durch die Verwendung einer Deckplatte ein direkter Kontakt des oberen Pressstempels bzw. eines Trennmittels mit den optischen Fasern vermieden. Eine Deckplatte muss jedoch nicht zwangsweise vorhanden sein. Die Deckplatte muss nicht zwangsweise plattenförmig sein. Wesentlich ist die ebene Oberfläche, die in Kontakt mit den Fasern kommt. Im Allgemeinen ist unter einer Deckplatte daher auch ein beliebig geformtes Deckelement mit zumindest einer ebenen Oberfläche zu verstehen.

Eine weitere bevorzugte Ausführungsform ist dadurch gekennzeichnet, dass die lineare thermische Ausdehnung im Temperaturbereich 20 bis 300°C der Deckplatte maximal 3.10⁻⁶/K kleiner, vorzugsweise jedoch größer als diejenige des Mantelglases der optischen Fasern ist und dass die Deckplatte (3) aus einem Glastyp ist, dessen Erweichungstemperatur E_{W} über dem höchsten E_{W} der in den optischen Fasern verwendeten Glastypen, vorzugsweise mindestens 50 K über der höchsten Erweichungstemperatur E_{W} der in den optischen Fasern verwendeten Glastypen liegt. Die genannten Eigenschaften wurden bereits im Zusammenhang mit der Trägerplatte erläutert. Trägerplatte und Deckplatte können sowohl aus dem gleichen Material bestehen, sowie auch dieselben Abmessungen aufweisen.

Eine weitere bevorzugte Ausführungsform des erfindungsgemäßen Lichtleiters ist dadurch gekennzeichnet, dass weitere optische Mittel wie Vorsatzlinsen oder intrinsische Zylinderlinsen vor der Eintrittsfläche angebracht sind, oder die Einkoppelfläche mit einer Antireflexbeschichtungen versehen ist. Diese optischen Elemente sowie können die Einkoppeleffizienz insbesondere von Laserstrahlung in das Einkoppelende erhöhen.

Gegenstand der Erfindung ist auch die Bereitstellung eines Verfahrens zur Herstellung des erfindungsgemäßen Lichtleiters. Das erfindungsgemäße Verfahren zur Herstellung eines optischen Einkoppelendes eines Lichtleiters umfassend eine Vielzahl optischer Fasern mit einem im Ausgangszustand im wesentlichen kreisförmigen Querschnitt ist dadurch gekennzeichnet, dass die optischen Fasern ein- oder mehrlagig auf einer Trägerplatte angeordnet und fixiert werden, die Fasern dann in einem Heißpressverfahren unter Einbringung von Kraft und Wärme zumindest in einem Teilbereich der Trägerplatte derart umgeformt werden, dass die optischen Fasern sich zumindest gruppenweise untereinander formschlüssig verbinden und sich die unterste Lage der Fasern formschlüssig mit der Trägerplatte verbindet, wodurch eine Verschmelzzone entsteht, in welcher die Fasern zumindest gruppenweise formschlüssig untereinander verbunden sind und die unterste Lage der Fasern formschlüssig mit der Trägerplatte verbunden ist, eine sich daran anschließende Übergangszone, in welcher die Querschnittsform der optischen Fasern von einer im wesentlichen mehreckigen Form in eine im Wesentlichen kreisförmige Form übergeht und eine sich daran anschließende Auslaufzone, in welcher die optischen Fasern eine im Wesentlichenkreisförmige Querschnittsform aufweisen.

Das Verfahren wird in der folgenden Beschreibung in den Prozessschritten Vorkonfektionierung, Heißpressen und Konfektionierung dargestellt.

Die Vorkonfektionierung umfasst die Bereitstellung von Fasern und Trägerplatte sowie die Anordnung und Fixierung der Fasern auf der Trägerplatte. Die Fasern werden auf der Trägerplatte einlagig oder mehrlagig bevorzugt in einer Breite angeordnet, welche der Breite des Laserstrahls entspricht, der später in den Lichtleiter eingekoppelt werden soll. Die Trägerplatte muss nicht zwangsweise plattenförmig sein. Wesentlich ist die ebene Oberfläche, die in Kontakt mit den Fasern kommt. Im Allgemeinen ist unter einer Trägerplatte daher auch ein beliebig geformtes Trägerelement mit zumindest einer ebenen Oberfläche zu verstehen. Im Falle einer mehrlagigen Anordnung bilden die Fasern auf der Trägerplatte bevorzugt eine zumindest teilweise hexagonale Anordnung. Des Weiteren umfasst die Vorkonfektionierung eine Fixierung der Fasern vor dem Heißpressverfahren im Bereich der Trägerplatte oder im Bereich des Faserüberstandes, der über die Trägerplatte hinausreicht.

Das Heißpressverfahren ist in einer bevorzugten Ausführungsform schematisch in Figur 3 dargestellt. Es erfolgt vorzugsweise in einer vertikalen Achse. Die folgende Beschreibung geht im Folgenden von dieser vertikalen Ausrichtung aus, auch wenn diese nicht zwingend erforderlich ist. Die für das Verfahren eingesetzte Heißpresse beinhaltet vorzugsweise zwei Pressstempel, die auf einer vertikalen Achse übereinander und mit zueinander ausgerichteten Pressflächen angeordnet sind, so dass es einen unteren Pressstempel mit oben liegender Pressfläche und einen oberen Pressstempel mit unten liegender Pressfläche gibt. Mindestens einer der beiden Pressstempel ist auf einer vertikalen Achse verfahrbar. Vorzugsweise ist dies der obere Pressstempel, so dass es einen unteren Pressstempel mit vorzugsweise fester Position gibt, und einen oberen Pressstempel, der entlang einer vertikalen Achse verfahrbar ist. Die Stempel sind beheizbar. Die vorkonfektionierte mehrschichtige Anordnung wird üblicherweise zwischen den Pressstempeln in einem Vorheizschritt erwärmt, wobei der obere Presstempel ohne Krafteinwirkung oder mit nur geringer Auflagekraft von maximal 20 N aufgesetzt werden kann, um den Wärmeübergang zu verbessern. Eine homogene Temperaturverteilung innerhalb der vorkonfektionierten mehrschichtigen Anordnung kann dadurch erreicht werden, dass die Pressstempel etwas über den beabsichtigten Verschmelzbereich hinausragen, wie in Figur 3 dargestellt ist. Der folgende Umformschritt erfordert eine hinreichend geringe Viskosität der optischen Fasern. Erfahrungsgemäß entspricht diese Temperatur etwa dem Erweichungspunkt E_{W} der verwendeten Glaswerkstoffe der Fasern, bei dem ein Glas eine Viskosität von 10^{7.6} dPa·s aufweist. Setzt sich die optische Faser aus mehreren Glastypen zusammen, sind die Temperaturen entsprechend dem Glastyp mit dem höheren E_{W} festzulegen. Vorzugsweise erfolgt die Umformung bei einer möglichst geringen Temperatur. Bei dem Umformschritt wird der obere Presstempel von einer Startposition auf eine Endposition gefahren, wobei der eigentliche Umformweg, in dem eine Verformung erfolgt, den Kompressionsweg darstellt. Nach einer Haltezeit unter Beibehaltung der Umformtemperatur wird das Heißpressverfahren abgeschlossen durch einen Abkühlschritt, der entweder durch Absenkung der Pressstempeltemperaturen bei geschlossenen Pressstempeln oder durch ein langsames Öffnen der Pressstempel erreicht wird. Dabei ist wichtig, dass die verschmolzene mehrschichtige Anordnung nicht zu schnell abgekühlt wird, um mechanische Spannungen gering zu halten.

Im Anschluss an das Heißpressverfahren erfolgen weitere Nachverarbeitungsschritte zur abschließenden Konfektionierung der Einkoppelseite sowie des gesamten Lichtleiters. Diese umfassen die einseitige Entfernung des Faserüberstandes auf der Einkoppelseite, weitere Maßnahmen zur Fixierung und Stabilisierung der verpressten Fasern, die Endflächenbearbeitung der Einkoppelfläche mit Schleif- und Polierprozessen, sowie in der Regel eine Stecker- und/oder Schlauchmontage. So ist zum Beispiel ein Befüllen der verbleibenden Luftzwischenräume in dem zumindest teilweise verschmolzenen Faserband mit Kunststoffen, bevorzugt mit Klebstoff möglich, insbesondere die mechanisch empfindliche Übergangszone kann so geschützt werden. Alternativ kann auch ein Ausgießen mit Silikon erfolgen. Vorzugsweise wird ein Kleber eingesetzt, dessen Brechwert etwa dem Brechwert der optischen Fasern, insbesondere dem Brechwert des lichtleitenden Kernglases entspricht. Dadurch können Bruchstellen in einzelnen Fasern optisch gekittet werden, zumindest können Rückreflektionen in den betroffenen Fasern deutlich verringert werden. Des Weiteren können die Distanzstücke entfernt werden oder auch in dem Bauteil verbleiben und mit Klebstoff fixiert werden. Anschließend weist das Einkoppelende eine ausreichende Festigkeit für mechanische Schleif- und Polierprozesse auf. Nach der Konfektionierung der Einkoppelseite erfolgen weitere Schritte zur Konfektionierung des Lichtleiters, welche in der Regel Schlauchmontage sowie die Konfektionierung des Auskoppelendes umfassen.

Das Material von Träger- und Deckplatte wird vorzugsweise so ausgewählt, dass dieses bei der Umformtemperatur noch eine ausreichende Festigkeit aufweist und sich die optischen Fasern beim Heißpressen nicht in die Platten abformen. Handelt es sich bei Träger- und Deckplatte um Glasplatten, so sollte der Erweichungspunkt E_{W} des Glases mindestens 50K über dem höchsten E_{W} der in den optischen Fasern verwendeten Gläser liegen, um dies sicherzustellen.

Bei den optischen Fasern handelt es sich bevorzugt um Stufenindex-Multimode-Glasfasern mit einem einheitlichen Faserdurchmesser D, wobei das Verhältnis der Mantelstärke zur beabsichtigten Anwendungswellenlänge kleiner als 5, besonders bevorzugt zwischen 0,5 und 3 beträgt.

In einer bevorzugten Ausführungsform des Verfahrens werden die optischen Fasern auf der Trägerplatte einlagig, parallel und bündig angeordnet, so dass die Fasern in Form eines Bandes mit einer Breite und einer Höhe angeordnet sind. Das Faserband wird dabei bevorzugt durch seitliche Begrenzungselemente begrenzt und verdichtet, so dass die Fasern zumindest innerhalb eines für die Verschmelzzone vorgesehenen Teilabschnittes des Faserbandes entlang der Richtung der optischen Fasern den Querschnitt nahezu optimal, d.h. mit höchstmöglicher Packungsdichte, ausfüllen. Im Falle einer einlagigen Anordnung liegen die Einzelfasern in diesem Bereich bündig nebeneinander und die Höhe des Faserbandes entspricht dem Faserdurchmesser D. Außerhalb des für die Verschmelzung vorgesehenen Teilbereiches des Faserbandes, ist eine bündige oder parallele Anordnung der Fasern nicht zwingend erforderlich. Das Faserband kann sich in diesem Bereich z.B. in mehrere Teilbereiche bestehend aus einer oder mehreren Fasern aufteilen, ebenso können die Teilbereiche übereinander liegen und sich kreuzen. Ebenso ist eine Mischung oder auch eine definierte Umordnung von Einzelfasern oder den oben erwähnten Teilbereichen möglich.

Die Elemente zur seitlichen Begrenzung des Faserbandes können nach der Fixierung des Faserbandes wieder entfernt werden. In einer bevorzugten Ausführungsform der Erfindung verbleiben diese jedoch seitlich des Faserbandes und erfüllen während des Heißpressverfahrens die Funktion von Distanzstücken, d.h. sie begrenzen den Verfahrweg der Heißpresse in Verbindung mit einer kraftgesteuerten Wegsteuerung der Heißpresse, wie weiter unten beschrieben ist. Es sind auch weitere Ausführungsformen mit einem einteiligen Distanzstück einseitig oder beidseitig des fixierten Faserbandes möglich. Das Distanzstück kann ebenso in Verbund mit Träger- und oder Deckplatte ausgeführt sein.

Bei dem Heißpressen werden die Fasern bevorzugt soweit verformt, dass sie sich formschlüssig aneinander legen, jedoch die Querschnittsfläche der Einzelfasern im wesentlichen nicht reduziert werden. Die Einzelfasern bilden dann bevorzugt annähernd rechteckige Querschnitte aus, wie in Figur 4 dargestellt ist, wobei die Breite einer Einzelfaser dem Faserdurchmesser D entspricht und die Höhe theoretisch auf ca. 79% (π/4) reduziert wird. In der Praxis kann es jedoch zu Abweichungen von dieser theoretischen Form kommen.

In einer weiteren bevorzugten Ausführungsform des Verfahrens werden die optischen Fasern auf der Trägerplatte einlagig, parallel und in gleichmäßigen Abständen angeordnet, wobei zwei Fasern jeweils einen Abstand von 0 bis zum 5-fachen des Faserdurchmessers D aufweisen. Diese Ausführungsform ist in Figur 5 schematisch dargestellt, wobei in der oberen Teilfigur die auf der Trägerplatte angeordneten Fasern und in der in der unteren Teilfigur die verpressten Fasern dargestellt sind. Auch in diesem Fall werden die Fasern beim Heißpressen bevorzugt soweit verformt, dass sie sich formschlüssig aneinander legen, jedoch die Querschnittsfläche der Einzelfasern im wesentlichen nicht reduziert werden. Dadurch kann im Vergleich zur bündigen Anordnung der Fasern eine geringere Spalthöhe des Einkoppelspaltes bei unverändertem Faserdurchmesser erreicht werden, wodurch die Einkoppeloberfläche reduziert wird und die Strahlqualität angehoben wird.

Eine weitere Ausführungsform des Verfahrens ist dadurch gekennzeichnet, dass nach Ankopplung des Lichtleiters an einen Laserdiodenbarren mit mehreren Emittern und nicht-emittierenden Bereichen zwischen den Emittern nur die Fasern, in welche Laserstrahlung eingekoppelt wird, in einem Auskoppelende zusammengefasst werden und Fasern, in welche keine Laserleistung eingekoppelt wird, nicht dem Auskoppelende zugeführt werden. Bevorzugt wird der erfindungsgemäße Lichtleiter an einen Halbleiterlaser mit mehreren Emittern angekoppelt, wobei die spaltförmige Einkoppelfläche des Lichtleiters stumpf oder aber über optische Elemente an die Emitterzeile gekoppelt wird. Abhängig von Emitterbreite, Emitterabstand, Faserdurchmesser und Höhe der Einkoppelfläche werden dabei einem Emitter und auch dem nicht-emittierenden Bereich zwischen zwei Emittern ein oder mehrere Fasern auf der Einkoppelfläche zugeordnet. Die Fasern, in welche keine Laserleistung eingekoppelt wird, können nach Ankopplung des Halbleiterlasers und dauerhafter Fixierung von Einkoppelende und Halbleiterlaser identifiziert werden und aus dem Faserbündel herausgeführt und/oder durchtrennt werden. Dadurch wird die Gesamtquerschnittsfläche des Faserbündels auf der Auskoppelseite reduziert und die Strahlqualität entsprechend angehoben.

Eine weitere Ausführungsform des Verfahrens ist dadurch gekennzeichnet, dass die optischen Fasern auf der Trägerplatte einlagig, parallel und in Gruppen von je 2 bis 5 Fasern angeordnet werden, wobei bei der späteren Kopplung der Einkoppelfläche des Lichtleiters mit einem Laserdiodenbarren einem Emitter jeweils eine Gruppe von Fasern zugeordnet ist und wobei in den Bereichen, die bei der späteren Kopplung der Einkoppelfläche des Lichtleiters mit einem Laserdiodenbarren der Fläche zwischen zwei Emittern zugeordnet sind, keine Fasern angeordnet werden. Diese Ausführungsform ist in Figur 6 schematisch dargestellt, wobei in der oberen Teilfigur die auf der Trägerplatte angeordneten Fasern und in der in der unteren Teilfigur die verpressten Fasern dargestellt sind. Bei dieser Ausführungsform entfällt das in der vorausgehenden Ausführungsform dargestellte Entfernen von Fasern aus dem Bündel, in welche nach Ankopplung an einen Halbleiterlaser keine Strahlung eingekoppelt werden muss. Allerdings müssen die Gruppen von Fasern exakt in dem Emitterabstand angeordnet sein.

Eine weitere Ausführungsform des Verfahrens ist dadurch gekennzeichnet, dass die Fasern mit einem zumindest einseitigen Überstand auf der Trägerplatte angeordnet werden und vor dem Heißpressverfahren zumindest einseitig im Bereich dieses Überstandes durch geeignete Mittel wie z.B. Klebeband oder Klebstoff temporär oder dauerhaft fixiert werden. Die Fixierung kann einseitig oder vorzugsweise zweiseitig erfolgen. In letzterem Fall werden die Fasern mit einem beidseitigen Überstand über die Trägerplatte angeordnet. Die Fixierung der Faseranordnung in den überstehenden Bereichen kann z.B. durch Klebstoff oder ein Klebeband erfolgen. Auf der Seite der späteren Einkoppelfläche kann eine temporäre oder dauerhafte Fixierung erfolgen, auf der gegenüberliegenden Seite wird vorzugsweise eine temporäre Fixierung verwendet, wie z.B. eine Klebeband, welches ohne Schädigung der Fasern vor der Endkonfektionierung des Lichtleiters wieder entfernt werden kann.

Eine weitere Ausführungsform des Verfahrens ist dadurch gekennzeichnet, dass die Fasern vor dem Heißpressverfahren auf der Trägerplatte in einem Bereich fixiert werden, der in dem Heißpressverfahren nicht verpresst wird. Die Trägerplatte umfasst dafür vorzugsweise neben einem für die Verschmelzzone und Übergangszone vorgesehenen Bereich einen Abschnitt, in welchem die Fasern vorzugsweise vor dem Heißpressverfahren relativ zur Trägerplatte fixiert werden. Dadurch wird sichergestellt, dass die Fasern in der Übergangszone nach dem Heißpressverfahren keinen mechanischen Belastungen mehr ausgesetzt sind. Dabei kann es sich um eine direkte Fixierung handeln, z.B. eine Verklebung der Fasern auf der Trägerplatte, die Befestigung kann aber auch indirekt über Elemente erfolgen, die ihrerseits direkt oder indirekt mit der Trägerplatte verbunden sind, wie zum Beispiel der Deckplatte. Wesentlich ist also, dass die Fasern auch in dem nicht verpressten Bereich durch geeignete Mittel direkt oder indirekt relativ zur Trägerplatte fixiert und damit vor Bruch geschützt sind.

Als besonders vorteilhaft hat sich insbesondere die Verwendung eines lichthärtenden Klebstoffes in Verbindung mit einer transparenten Deck- und/oder Trägerplatte herausgestellt. Der lichthärtende Kleber kann bei dieser Variante zwischen Träger- und Deckplatte eingebracht werden und dessen Ausbreitungsbereich kann gezielt durch Lichteinkopplung durch die Deckplatte und/oder Trägerplatte gesteuert werden. Dadurch kann insbesondere vermieden werden, dass in den für die Verschmelzzone vorgesehenen Bereich Klebstoff gelangt. Selbstverständlich kann auch ohne Vorhandensein einer Deckplatte eine Verklebung auf der Trägerplatte durchgeführt werden.

Eine weitere Ausführungsform des Verfahrens ist dadurch gekennzeichnet, dass die Fasern in der Verschmelzzone soweit verpresst werden, dass die aktive Querschnittsfläche des Einkoppelendes in der Verschmelzzone formschlüssig mit den optischen Fasern ausgefüllt ist und die Gesamtquerschnittsfläche der Einzelfasern in der Verschmelzzone im wesentlichen der Gesamtquerschnittsfläche der Einzelfasern vor der Verschmelzung entspricht oder maximal 25% kleiner als diese ist. Das bedeutet, dass die Fasern bevorzugt soweit verformt werden, dass sie sich formschlüssig aneinander legen, jedoch die Querschnittsfläche der Einzelfasern um maximal 25%, jedoch vorzugsweise nicht reduziert wird. Bei einer stärkeren Reduzierung der Spalthöhe kann es zu einer starken Beeinträchtigung der lichtleitenden Eigenschaften des Faserbandes kommen, da es aufgrund eines dann unvermeidbaren Materialflusses in Richtung der Faserachse während der Verschmelzung zu einer Art Aufstauchung der Faser in axialer Richtung kommen kann. Durch die Aufstauchung der Faser kann auch deren optische Grenzfläche verformt werden, was die beschriebene Beeinträchtigung der lichtleitenden Eigenschaften verursachen kann. Es kann jedoch im Einzelfall und in Abhängigkeit der Materialkombination vorteilhaft sein, wenn die Gesamtquerschnittsfläche der Einzelfasern in der Verschmelzzone die Gesamtquerschnittsfläche der Einzelfasern im unverschmolzenen Faserbündel leicht oder maximal um 25% unterschreitet. Dadurch können z.B. Schwankungen der Einzelfaserdurchmesser kompensiert werden oder die formschlüssige Verbindung bzw. Verschmelzung verbessert werden. Bei einer deutlich geringeren Reduzierung der Spalthöhe werden die verformten Fasern sich hingegen nicht formschlüssig aneinanderlegen, was zu Einkoppelverlusten und zu einer Reduzierung der mechanischen Festigkeit des Einkoppelendes führen kann. Ebenso kann es zu Ausbrüchen der Faserenden bei der Endenbearbeitung kommen.

Eine weitere Ausführungsform des Verfahrens ist dadurch gekennzeichnet, dass für die Begrenzung des Verfahrweges der Heißpresse seitlich des Faserbündels zumindest ein Distanzstück auf die Trägerplatte aufgebracht wird, oder als Bestandteil von Träger- oder Deckplatte vorhanden ist. Die angestrebte Reduzierung der Spalthöhe ist sehr gering, da sie in dem Fall der einlagigen Verschmelzung nur ca. 20% des Einzelfaserdurchmessers beträgt und daher für typische Einzelfaserdurchmesser von 50µm bis 100µm nur 10µm bis 20µm beträgt. Diese sehr geringe Reduzierung der Spalthöhe ist als Kompressionsweg einer Heißpresse schwierig umzusetzen, da der angestrebte Kompressionsweg schon im Bereich der thermischen Ausdehnungen der Bauelemente der Heißpresse liegt. Bevorzugt werden die Distanzstücke in Verbindung mit einem kraftgesteuerten Anfahren der Endposition eingesetzt. Dafür wird beim Zusammenfahren der Pressstempel die für die Kompression benötigte Kraft gemessen. Wenn das Faserband soweit komprimiert ist, dass der obere Pressstempel bzw. die darauf liegende Deckplatte die Distanzstücke erreicht hat, steigt die Kraft sprunghaft an, was als Abschaltsignal für das Verfahren des oberen Pressstempels dient. Ein kraftgesteuertes Anfahren der Endposition ist auch ohne die Verwendung von Distanzstücken möglich, da die Umformkraft auch ohne Distanzstücke ansteigt, sobald die Fasern formschlüssig verschmolzen sind und keine Luftzwischenräume mehr vorhanden sind. Ein deutlicherer Kraftanstieg und damit eine präzisere Begrenzung des Verfahrweges sind jedoch durch die Verwendung von Distanzstücken möglich.

Daher ist in einer bevorzugten Ausführungsform der Erfindung vorgesehen, für die Einhaltung dieses sehr geringen Kompressionsweges mindestens ein, bevorzugt zwei oder mehr Distanzstücke einseitig oder bevorzugt beidseitig der Fasern auf die Trägerplatte aufzubringen, deren Dicke der Sollhöhe der Einkoppelfläche nach der Verschmelzung entspricht. Bei dem bzw. den Distanzstücken handelt kann es sich bevorzugt gleichzeitig um die seitlichen Begrenzungselemente der Fasern handeln, die dann eine Doppelfunktion erfüllen. Ein Distanzstück kann aber auch als Bestandteil von Träger- oder Deckplatte ausgebildet sein.

Eine weitere Ausführungsform des Verfahrens ist dadurch gekennzeichnet, dass das Heißpressverfahren mit einem Paar gegenüberliegender Pressstempel durchgeführt wird, welche einen Teilbereich aufweisen, in dem die Pressflächen eben und zueinander parallel sind, und einen sich anschließenden Teilbereich, in dem sich der Abstand der Pressflächen gleichmäßig vergrößert, wodurch die Ausdehnung der Übergangszone beeinflusst wird. Die Erfinder haben erkannt, dass die Ausdehnung der Übergangszone in Richtung der Fasern, in der die Querschnittsform der Faser von der verpressten Form in die ursprüngliche Form übergeht, von großer Bedeutung ist. Einerseits führt ein Wechsel der Querschnittsform einer optischen Faser innerhalb einer Länge, die wenigen Faserdurchmessern entspricht, zu Lichtauskopplung, da die opt. Grenzfläche zwischen Kern- und Mantelglas dann zwangsweise große Winkel relativ zur Faserachse aufweist. Andererseits ist eine Übergangszone zu geringer Länge auch mechanisch sehr empfindlich. So hat sich gezeigt, dass die Verschmelzung eines Faserbandes zwischen einer Trägerplatte und einer Deckplatte gleicher Form und Größe, die bündig aufeinander gelegt und vollflächig verschmolzen werden, instabil ist. In diesem Fall stellt der gesamte Bereich des Faserbandes zwischen Träger- und Deckplatte die Verschmelzzone dar und es bildet sich eine sehr kurze Übergangszone direkt außerhalb der Trägerplatte aus. Die entsprechend hergestellten Bauteile sind direkt nach dem Heißpressen im Bereich der Übergangszone gebrochen.

In einer besonders bevorzugten Ausführungsform der Erfindung wird daher die Ausdehnung der Übergangszone in Richtung der Fasern dadurch vergrößert, dass ein Paar gegenüberliegender Pressstempel eingesetzt wird, welche in einem Teilbereich, zueinander parallele ebene Pressflächen haben, und einen sich anschließenden Teilbereich haben, in dem sich der Abstand der Pressflächen zunehmend vergrößert, wodurch die Breite der Übergangszone gezielt eingestellt werden kann. Dabei entspricht der Bereich, in dem die Pressstempel die parallelen ebene Pressflächen aufweisen, in dem gepressten Bauteil der Verschmelzzone, und der Bereich, indem der Abstand der Presstempel um den Kompressionsweg der Presse ansteigt, etwa der Übergangszone in dem verpressten Bauteil. Eine bevorzugte Ausführungsform der Pressstempel wird zum Beispiel erreicht durch eine Pressfläche mit einem vorderen Bereich der Pressfläche, in dem die Pressfläche plan und senkrecht zur Pressrichtung ist, sowie einen sich anschließenden hinteren Bereich der Pressfläche, der mit einem Winkel von ca. 5° abgewinkelt ist, so dass die hinteren Pressflächen der Stempel in der Heißpresse einen Winkel von ca. 10° einschließen. Der Übergangsbereich der Pressfläche zwischen vorderer und hinterer Pressfläche wird dabei vorzugsweise leicht verrundet. Der hintere Bereich der Pressfläche muss im Allgemeinen nicht plan sein, sondern kann z.B. auch eine Wölbung aufweisen. Die sich im Wesentlichen aus zwei planen Flächen ergebenden Pressfläche stellt fertigungstechnisch die bevorzugte Variante dar.

Eine weitere Ausführungsform des Verfahrens ist dadurch gekennzeichnet, dadurch gekennzeichnet, dass zur Vermeidung eines Anhaftens oder Anglasens der Trägerplatte und/oder der Deckplatte an den Pressstempeln ein Trennmittel verwendet wird. Auf die Pressstempel und/oder das vorkonfektionierte Gebilde kann ein Hochtemperaturtrennmittel wie z.B. Bornitrid aufgebracht werden, um eine Anhaftung der Presswerkzeuge zu vermeiden.

Eine weitere Ausführungsform des Verfahrens ist dadurch gekennzeichnet, dadurch gekennzeichnet, dass weitere Konfektionierungsschritte wie Maßnahmen zur Fixierung und Stabilisierung, z.B. Befüllen mit Klebstoff, sowie Endflächenbearbeitung, Stecker- und Schlauchmontage durchgeführt werden. Ferner können weitere optische Mittel wie Antireflexbeschichtungen auf die Einkoppelfläche aufgebracht werden, oder optische Linsen, insbesondere zylindrische Linsen vor dieser angeordnet werden. Einen Spezialfall stellt eine intrinsische Zylinderlinse dar, wobei die Zylinderlinse aus den verpressten Fasern selbst gebildet wird, deren Eintrittsoberfläche durch einen entsprechenden Schleif- und Polierprozess in die entsprechende Zylinderform erfolgt. Dieser Schleif- und Polierprozess erfordert jedoch eine sehr hohe mechanische Festigkeit der verpressten Fasern, der mit dem vorliegenden Verfahren erreicht werden kann, da die Fasern zusammen mit Trägerplatte und Deckplatte eine hohe Festigkeit aufweisen. Die Zylinderlinsen erfüllen dabei die Funktion einer Kollimation der fast axis, die Antireflexbeschichtung vermeidet die Einkoppelverluste aufgrund von Fresnel-Reflektion.

Eine weitere Ausführungsform des Verfahrens ist dadurch gekennzeichnet, dass vor dem Heißpressverfahren eine Deckplatte auf den optischen Fasern aufgebracht wird, welche sich im Heißpressverfahren in der Verschmelzzone formschlüssig mit den optischen Fasern der obersten Lage der Fasern verbindet. Die Höhe des Faserbandes entspricht dann dem Abstand von Träger- und Deckplatte. Eine Deckplatte erfüllt nach dem Heißpressverfahren die Aufgabe einer weiteren Stabilisierung des Einkoppelendes. Ferner wird durch die Verwendung einer Deckplatte ein direkter Kontakt des oberen Pressstempels bzw. eines Trennmittels mit den optischen Fasern vermieden, welches sonst benötigt würde, um ein Anhaften der Fasern an dem oberen Pressstempel zu vermeiden. Eine Deckplatte muss jedoch nicht zwangsweise vorhanden sein. Der symmetrische Aufbau Trägerplatte-Fasern-Deckplatte hat bei Verwendung der gleichen Materialien und Materialstärken für Trägerplatte und Deckplatte ferner den Vorteil, dass das Einkoppelende einen symmetrischen Aufbau aufweist und sich bei Temperaturgradienten nicht durchbiegt. In einer bevorzugten Ausführungsform der Erfindung handelt es sich daher bei der Deckplatte und der Trägerplatte um dasselbe Material in derselben Materialstärke.

Der erfindungsgemäße Lichtleiter wird bevorzugt zur Kopplung mit einem Laserdiodenbarren, bevorzugt einem Hochleistungslaserdiodenbarren verwendet. In das erfindungsgemäß hergestellte Einkoppelende eines Lichtleiters kann zum Beispiel durch stumpfe Kopplung die Strahlung eines Hochleistungsdiodenlasers eingekoppelt werden, wobei die Einkoppelfläche mit einem geringen Abstand vor der Emitterzeile des Laserbarrens positioniert wird. Sowohl eine stumpfe Kopplung als auch eine Kopplung mit weiteren optischen Mitteln wie Zylinderlinsen, Antireflexschichten sind von der Erfindung umfasst, wobei die optischen Mittel Bestandteil des Lichtleiters oder des Hochleistungsdiodenlasers oder zwischen diesen angeordnet sein können

Besonders vorteilhaft ermöglicht der erfindungsgemäße Lichtleiter eine vereinfachte Justage des Einkoppelendes vor dem Laserdiodenbarren in der Achse senkrecht zum Halbleiterübergang ermöglicht. Im optimalen Fall kann eine justagefreie Positionierung erfolgen, in dem der Laserdiodenbarren und das Einkoppelende auf einer gemeinsamen Grundplatte voreinander ausgerichtet werden. Vorraussetzung ist, dass die Trägerplatte sehr geringe Dickentoleranzen aufweist, was z.B. durch verfügbare Floatgläser sichergestellt werden kann.

Bevorzugte Ausführungsformen der Erfindung werden anhand der folgenden Figuren näher erläutert, wobei die Figuren 1 bis 4 die Ausführungsform darstellen, in der die Fasern einlagig und bündig auf der Trägerplatte angeordnet sind, und die Figuren 5 und 6 die Ausführungsformen darstellen, bei denen die Fasern in gleichmäßigen Abständen oder Gruppen auf der Trägerplatte angeordnet sind.
Figur 1. Perspektivische Ansicht des Einkoppelendes des Lichtleiters mit einlagiger, bündiger Anordnung der Fasern, schematisch
Figur 2. Querschnitt durch das Einkoppelende in der Auslaufzone mit einlagiger, bündiger Anordnung der Fasern, schematisch
Figur 3. Perspektivische Ansicht des Einkoppelendes sowie der Pressstempel vor dem Heißpressverfahren mit einlagiger, bündiger Anordnung der Fasern, schematisch
Figur 4. Schematische Darstellung der Einkoppelfläche nach Schleifen und Polieren mit einlagiger, bündiger und formschlüssiger Anordnung der Fasern
Figur 5. Querschnitt durch das Einkoppelende in der Verschmelzzone vor und nach dem Heißpressen mit äquidistant angeordneten Fasern, schematisch
Figur 6. Querschnitt durch das Einkoppelende in der Verschmelzzone vor und nach dem Heißpressen mit in äquidistanten Gruppen angeordneten Fasern, schematisch

Zum Zwecke der Darstellung wird in den Figuren eine schematische Darstellung verwendet, die die realen Größenverhältnisse nicht maßstabsgetreu wiedergibt. Auch die Anzahl der optische Fasern ist für die Darstellungszwecke angepasst worden. Ebenso wird in der Darstellung auf weitere nicht wesentliche Elemente wie Steckergehäuse, etc verzichtet.

In der perspektivischen Ansicht der Figur 1 ist das Einkoppelende (1) eines erfindungsgemäßen Lichtleiters dargestellt, umfassend die Trägerplatte (2), die an der Stirnfläche (6) des Einkoppelendes verformten, formschlüssig verbundenen Fasern (4, 5) sowie eine Deckplatte (3). Beidseitig der Fasern sind Distanzstücke (11) angeordnet, die nach dem Heißpressverfahren flächigen Kontakt mit Trägerplatte und Deckplatte aufweisen. Diese befinden sich seitlich des Faserbandes und erstrecken sich in Richtung der Fasern lediglich über den Bereich bzw. einen Teilbereich der Verschmelzzone (8). An die Verschmelzzone (8) schließt sich die Übergangszone (9) sowie eine Auslaufzone (10) an, wobei das Einkoppelende (1) lediglich im Bereich der Verschmelzzone (8) verpresst ist. Die optischen Fasern (12, 13) sind außerhalb des Einkoppelendes (1) typischerweise zu einem Faserbündel (7) zusammengefasst und von einem Schlauch umgeben.

In der schematischen Darstellung des Querschnittes durch das Einkoppelende (1) im Bereich der Auslaufzone in Figur 2 sind ebenfalls Trägerplatte (2) und Deckplatte (3) zu sehen, sowie die optischen Fasern (12, 13). Die optischen Fasern (12, 13) sind in diesem Bereich nicht verschmolzen, sondern weisen einen im Wesentlichen runden Querschnitt auf. Sie sind in dem vorliegenden Beispiel in einen Klebstoff (14) eingebettet.

Das Heißpressverfahren ist schematisch in Figur 3 dargestellt. Es umfasst zum einen das für das Heißpressverfahren vorkonfektionierte Gebilde sowie auch den oberen und unteren Pressstempel (16, 15).

Die optischen Fasern (13, 14) bilden in dem Beispiel ein einlagiges Faserband zwischen Trägerplatte (2) und Deckplatte (3), seitlich schließen sich Distanzstücke (11) an. Durch Fixierungsmittel (17) im Bereich des Faserüberstandes wird das Faserband für das Pressverfahren fixiert und seitlich zusammengehalten. Der obere Pressstempel (16) und der untere Pressstempel (15) weisen in dem dargestellten Beispiel einen zueinander symmetrischen Aufbau auf. Neben dem vorderen Bereich der Pressstempel, in dem die Pressflächen eben und parallel sind, ist der hintere Bereich mit einem Winkel von ca. 5° abgewinkelt, so dass sich der vertikale Abstand der Pressflächen im Bereich der späteren Übergangszone gleichmäßig vergrößert. Der Übergangsbereich auf der Pressfläche ist vorzugsweise leicht verrundet. In der Figur 3 ist die Abwinkelung der Pressfläche stark überzeichnet dargestellt.

Die Pressstempel (16, 15) und/oder die Träger- und Deckplatte (2, 3) sind vor dem Heißpressen mit einer Trennmittelschicht (18) versehen, um Anhaftungen zu vermeiden.

In Figur 4 ist die Stirnfläche des Einkoppelendes (6) mit den formschlüssig verbundenen Einzelfasern (4, 5) sowie Trägerplatte (2) und Deckplatte (3) schematisch dargestellt. Die Querschnittsform der Fasern entspricht im Wesentlichen einer Rechteckform mit verrundeten Ecken.

Figur 5 zeigt schematisch einen Querschnitt durch das Einkoppelende (1) in der Verschmelzzone (9) mit auf der Trägerplatte angeordneten Fasern vor dem Heißpressen (12, 13) in der oberen Teilfigur und nach dem Heißpressen (4,5), in der unteren Teilfigur, wobei die Fasern gemäß einer weiteren bevorzugten Ausführungsform nicht bündig angeordnet sind, sondern in gleichmäßigen Abständen.

Figur 6 zeigt schematisch einen Querschnitt durch das Einkoppelende (1) in der Verschmelzzone (9) mit auf der Trägerplatte angeordneten Fasern vor dem Heißpressen (12, 13) in der oberen Teilfigur und nach dem Heißpressen (4,5), in der unteren Teilfigur, wobei die Fasern gemäß einer weiteren bevorzugten Ausführungsform nicht bündig angeordnet sind, sondern in äquidistant angeordneten Gruppen von jeweils 3 Fasern.

In Tabelle 1 sind Materialeigenschaften von verwendetem Kern-, und Mantelglas der optischen Fasern sowie und Trägerglas bzw. Deckglas dargestellt.

**Tabelle1: Materialeigenschaften von Kern-, Mantel- und Träger- bzw. Deckglas**

| | | Kernglas 1 | Kernglas 2 | Mantelglas 1 | Mantelglas 2 | Trägerglas 1 | Trägerglas 2 | Trägerglas 3 |
|---|---|---|---|---|---|---|---|---|
| thermischer Ausdehnungskoeffizient α_{20..300} | [10⁻⁶/K] | 10,3 | 9,5 | 5,0 | 9,1 | 4,5 | 3,2 | 8,6 |
| Übergangstemperatur T_{g} | [°C] | 410 | 398 | 492 | 527 | 660 | 712 | 605 |
| Erweichungstemperatur E_{W} | [°C] | 589 | 575 | 720 | 716 | 880 | 970 | - |
| Brechungsindex n_{d} | | 1,58 | 1,563 | 1,49 | 1,51 | 1,53 | 1,51 | 1,51 |

Das Kernglas 1 mit einer thermischen Ausdehnung von 10,3·10⁻⁶/K ergibt mit dem Mantelglas 1 mit einer thermischen Ausdehnung von 5,0·10⁻⁶/K eine stabile optische Faser. Sowohl mit dem Trägerglas 1 mit einer thermischen Ausdehnung von 4,5·10⁻⁶/K als auch mit dem Trägerglas 3 mit einer thermischen Ausdehnung von 8,6·10⁻⁶/K ist die Herstellung eines erfindungsgemäßen Lichtleiters ohne Faserbruch im Einkoppelende möglich.

Das Kernglas 2 mit einer thermischen Ausdehnung von 9,5·10⁻⁶/K ergibt mit dem Mantelglas 2 mit einer thermischen Ausdehnung von 9,1·10⁻⁶/K ebenfalls eine stabile optische Faser. Mit diesem Fasertyp ist jedoch in Verbindung mit dem Trägerglas 2 mit einer thermischen Ausdehnung von 3,2·10⁻⁶/K keine stabile Verschmelzung möglich. Es tritt starker Faserbruch auf. In diesem Fall weist die thermische Ausdehnung der Trägerplatte einen um 5,9·10⁻⁶/K geringeren Wert als das Mantelglas auf, was zu Zugspannungen beim Ankühlen nach dem Verschmelzen in den Fasern und damit zu dem Bruch führt.

Ein weiteres Positivbeispiel ist weiterhin die Kombination von Kernglas 1, Mantelglas 2 und Trägerglas 3, welche ebenfalls stabile Verschmelzungen sehr guter Qualität ergibt.

Des Weiteren wurden Kombinationen getestet, in denen die thermische Ausdehnung des Trägerglases um ca. 2·10⁻⁶/K bis 3.10⁻⁶/K geringer als die thermische Ausdehnung des Mantelglases liegt. Diese weisen teilweise geringen Faserbruch auf und stellen somit etwa die Begrenzung des stabilen Bereiches dar.

Der erfindungsgemäße Lichtleiter, insbesondere das erfindungsgemäße Einkoppelende, hat gegenüber dem Stand der Technik zahlreiche Vorteile. Zum einen können gut verfügbare optische Fasern mit rundem Querschnitt eingesetzt werden. Die von einem Laserbarren emittierte Strahlung wird in einem relativ kleinen Querschnitt geführt, was eine nur geringe Verschlechterung der Strahlqualität bei der Einkopplung der Strahlung in den Lichtleiter bedeutet. Des Weiteren entfällt eine Positionierung von Einzelfasern vor den einzelnen Emittern eines Laserbarrens, es ist lediglich eine Positionierung des gesamten verschmolzenen Querschnittes vor der Emitterzeile des Laserbarrens erforderlich. Nach der Justierung können optische Fasern, die zwischen zwei Emittern des Laserbarrens liegen, nachträglich aus dem zusammengefassten Faserbündel entfernt werden.

Das Einkoppelende weist eine hervorragende mechanische Festigkeit auf. Die Fasern sind in dem verpressten Bereich sowie der kritischen Übergangszone gut vor Bruch geschützt und das Einkoppelende kann mit herkömmlichen Schleif- und Polierprozessen bearbeitet werden. Der Lichtleiter bzw. dessen Einkoppelende weist eine hervorragende Einkoppeleffizienz auf, da ein Großteil seiner Stirnfläche mit formschlüssig verbundenen Fasern gefüllt ist. Es treten also keine Verluste durch Zwischenräume zwischen den Fasern auf. Klebstoffe, welche durch die Laserstrahlung zersetzt werden können, kommen im Bereich der Lichteinkoppelfläche nicht zum Einsatz.

Ein weiterer Vorteil ist in dem vorzugsweise transparenten Aufbau zu sehen, welcher die Verwendung von lichthärtbaren Klebstoffen innerhalb des Einkoppelendes sowie auch zur Fixierung desselben z.B. auf einer Grundplatte ermöglicht. Im Vergleich zu thermisch härtbaren Systemen kann die benötigte Zeit für die Verklebung so deutlich reduziert werden.

Die Verwendung von Glas als Material von Träger und Deckplatte hat ferner den Vorteil, dass die Endenbearbeitung mit Schleif- und Polierprozesse keine Probleme bereitet und hochwertige optische Einkoppelflächen erreicht werden. Bei ungleichen Werkstoffen wie Glas und Metall können sich beim Schleifen und Polieren Probleme wie Gratbildung, Verschmierung von Metallpartikeln in der Faseroberfläche und insbesondere ein ungleichmäßiger Abtrag durch stärkeren Abtrag der Materialien mit einer geringeren Schleifhärte ergeben.

### Bezugszeichenliste:

- 1: Einkoppelende
- 2: Trägerplatte
- 3: Deckplatte
- 4, 5: Optische Fasern nach Heißpressen, zumindest teilweise formschlüssig verbunden
- 6: Stirnfläche des Einkoppelendes
- 7: Faserbündel
- 8: Verschmelzzone
- 9: Übergangszone
- 10: Auslaufzone
- 11: Distanzstück
- 12, 13: Optische Fasern mit rundem Querschnitt / vor dem Heißpressen
- 14: Klebstoff
- 15: Unterer Pressstempel
- 16: Oberer Pressstempel
- 17: Fixierung im Bereich des Faserüberstandes
- 18: Trennmittelschicht

## Patentansprüche

1. Lichtleiter beinhaltend eine Mehrzahl optischer Fasern mit einem Einkoppelende (1) und einem oder mehreren Auskoppelenden, wobei das Einkoppelende (1) aufweist
eine Verschmelzzone (8), in welcher die Fasern (4, 5) zumindest teilweise formschlüssig untereinander verbunden sind,
daran anschließend eine Übergangszone (9), in welcher der Querschnitt der optischen Fasern (4, 5) von einer im wesentlichen mehreckigen Form in eine im Wesentlichen kreisförmige Form übergeht, und
daran anschließend eine Auslaufzone (10), in welcher die Fasern (12, 13) eine im Wesentlichen kreisförmige Querschnittsform aufweisen, **dadurch gekennzeichnet, dass**
die Fasern in einer Monolage oder auch mehreren Lagen auf einer Trägerplatte (2) angeordnet sind und die Fasern der untersten Lage im Bereich der Verschmelzzone (8) formschlüssig mit der Trägerplatte (2) verbunden sind
und dass die den Fasern zugewandte Oberfläche der Trägerplatte (2) eine mittlere Rautiefe R_{z} < 1µm, besonders bevorzugt R_{z} < 0,2µm, aufweist.

2. Lichtleiter nach Anspruch 1,
**dadurch gekennzeichnet, dass** es sich bei den optischen Fasern um Stufenindex-Multimode-Glasfasern mit einem einheitlichen Faserdurchmesser D handelt, und dass das Verhältnis der Mantelstärke zur beabsichtigten Anwendungswellenlänge kleiner als 5, besonders bevorzugt zwischen 0,5 und 3 beträgt.

3. Lichtleiter nach mindestens einem der Ansprüche 1 bis 2,
**dadurch gekennzeichnet, dass** die lineare thermische Ausdehnung im Temperaturbereich 20°C bis 300°C der Trägerplatte (2) maximal 3·10⁻⁶/K kleiner, vorzugsweise jedoch größer als diejenige des Mantelglases der optischen Fasern ist.

4. Lichtleiter nach mindestens einem der Ansprüche 1 bis 3,
**dadurch gekennzeichnet, dass** die Fasern im Bereich der Auslaufzone (10) und/oder der Übergangszone (9) durch geeignete Mittel relativ zur Trägerplatte (2) fixiert sind, vorzugsweise durch einen Klebstoff.

5. Lichtleiter nach mindestens einem der Ansprüche 1 bis 4,
**dadurch gekennzeichnet, dass** die Trägerplatte (2) aus einem Glastyp ist, dessen Erweichungstemperatur E_{W} über dem höchsten E_{W} der in den optischen Fasern verwendeten Glastypen, vorzugsweise mindestens 50 K über der höchsten Erweichungstemperatur E_{W} der in den optischen Fasern verwendeten Glastypen liegt.

6. Lichtleiter nach mindestens einem der Ansprüche 1 bis 5,
**dadurch gekennzeichnet, dass** die optischen Fasern im Bereich der Übergangszone (9) und Verschmelzzone (8) einlagig, parallel und bündig angeordnet sind und im Bereich der Verschmelzzone (8) einen annähernd rechteckigen Querschnitt aufweisen, formschlüssig angeordnet sind und gemeinsam eine spaltförmige Einkoppelfläche ausbilden, deren Höhe zwischen 60% und 90% des Faserdurchmessers D beträgt.

7. Lichtleiter nach mindestens einem der Ansprüche 1 bis 5,
**dadurch gekennzeichnet, dass** die optischen Fasern im Übergangsbereich von Auslaufzone und Übergangszone (9) einlagig, parallel und in gleichmäßigen Abständen parallel angeordnet sind, wobei zwei Fasern jeweils einen Abstand von 0 bis zum 5-fachen des Faserdurchmessers D aufweisen, und im Bereich der Verschmelzzone (8) formschlüssig angeordnet sind und gemeinsam eine spaltförmige Einkoppelfläche ausbilden, deren Höhe zwischen 15% und 90% des Faserdurchmessers D beträgt.

8. Lichtleiter nach mindestens einem der Ansprüche 1 bis 5, **dadurch gekennzeichnet, dass** die optischen Fasern im Übergangsbereich von Auslaufzone und Übergangszone einlagig, parallel und in Gruppen von jeweils 1 bis 5 Fasern angeordnet sind, und im Bereich der Verschmelzzone (8) die Fasern jeweils einer Gruppe formschlüssig angeordnet sind, wobei bei der späteren Kopplung der Einkoppelfläche des Lichtleiters mit einem Laserdiodenbarren einem Emitter jeweils eine Gruppe von Fasern zugeordnet ist und wobei in den Bereichen der Einkoppelfläche, die bei der späteren Kopplung des Lichtleiters mit einem Laserdiodenbarren der Fläche zwischen zwei Emittern zugeordnet sind, keine Fasern angeordnet sind.

9. Lichtleiter nach mindestens einem der Ansprüche 1 bis 7,
**dadurch gekennzeichnet, dass** die Einkoppelfläche in der Verschmelzzone (8) formschlüssig mit den optischen Fasern (4, 5) ausgefüllt ist und die aufsummierte Querschnittsfläche der Einzelfasern in der Verschmelzzone (8) im wesentlichen der aufsummierten Querschnittsfläche der Einzelfa sern in der Auslaufzone (10) entspricht oder maximal 25% kleiner als diese ist.

10. Lichtleiter nach mindestens einem der Ansprüche 1 bis 8,
**dadurch gekennzeichnet, dass** die Fasern in der Verschmelzzone (8) an ihrer Oberseite mit einer Deckplatte (3) formschlüssig verbunden sind, wobei die den Fasern zugewandte Oberfläche der Deckplatte (3) eine mittlere Rautiefe R_{z}<1µm, besonders bevorzugt R_{z}<0,2µm aufweist, und die lineare thermische Ausdehnung im Temperaturbereich 20°C bis 300°C der Deckplatte maximal 3·10⁻⁶/K kleiner, vorzugsweise jedoch größer als diejenige des Mantelglases der optischen Fasern ist und wobei die Deckplatte (3) aus einem Glastyp ist, dessen Erweichungstemperatur E_{W} über dem höchsten E_{W} der in den optischen Fasern verwendeten Glastypen, vorzugsweise mindestens 50 K über der höchsten Erweichüngstemperatur E_{W} der in den optischen Fasern verwendeten Glastypen liegt.

11. Verfahren zur Herstellung eines optischen Einkoppelendes (1) eines Lichtleiters umfassend eine Vielzahl optischer Fasern mit einem im Ausgangszustand im wesentlichen kreisförmigen Querschnitt (12, 13), **dadurch gekennzeichnet, dass**
die optischen Fasern ein- oder mehrlagig auf einer Trägerplatte (2) angeordnet und fixiert werden,
die Fasern dann in einem Heißpressverfahren unter Einbringung von Kraft und Wärme zumindest in einem Teilbereich der Trägerplatte (2) derart umgeformt werden, dass die optischen Fasern sich zumindest gruppenweise untereinander formschlüssig verbinden und sich die unterste Lage der Fasern formschlüssig mit der Trägerplatte (2) verbindet,
wodurch eine Verschmelzzone (8) entsteht, in welcher die Fasern zumindest gruppenweise formschlüssig untereinander verbunden (4, 5) sind und die unterste Lage der Fasern formschlüssig mit der Trägerplatte verbunden ist, eine sich daran anschließende Übergangszone (9), in welcher die Querschnittsform der optischen Fasern von einer im wesentlichen mehreckigen Form in eine im wesentlichen kreisförmige Form übergeht und eine sich daran anschließende Auslaufzone (10), in welcher die optischen Fasern eine im wesentlichen kreisförmige Querschnittsform (12, 13) aufweisen und wobei die den Fasern zugewandte Oberfläche der Trägerplatte (2) eine mittlere Rautiefe R_{z} < 1µm, besonders bevorzugt R_{z} < 0,2µm, aufweist.

12. Verfahren nach Anspruch 11, **dadurch gekennzeichnet, dass** es sich bei den optischen Fasern um Stufenindex-Multimode-Glasfasern mit einem einheitlichen Faserdurchmesser D handelt, und dass das Verhältnis der Mantelstärke zur beabsichtigten Anwendungswellenlänge kleiner als 5, besonders bevorzugt zwischen 0,5 und 3 beträgt.

13. Verfahren nach mindestens einem der Ansprüche 11 bis 12, **dadurch gekennzeichnet, dass** die Fasern mit einem zumindest einseitigen Überstand auf der Trägerplatte (2) angeordnet werden und vor dem Heißpressverfahren zumindest einseitig im Bereich dieses Überstandes durch geeignete Mittel wie z.B. Klebeband oder Klebstoff (17) temporär oder dauerhaft fixiert werden.

14. Verfahren nach mindestens einem der Ansprüche 11 bis 13, **dadurch gekennzeichnet, dass** die Fasern vor dem Heißpressverfahren auf der Trägerplatte (2) in einem Bereich fixiert werden, der in dem Heißpressverfahren nicht verpresst wird.

15. Verfahren nach mindestens einem der Ansprüche 11 bis 14, **dadurch gekennzeichnet, dass** die Fasern in der Verschmelzzone (8) soweit verpresst werden, dass die aktive Querschnittsfläche des Einkoppelendes in der Verschmelzzone (8) formschlüssig mit den optischen Fasern (4, 5) ausgefüllt ist und die Gesamtquerschnittsfläche der Einzelfasern in der Verschmelzzone im wesentlichen der Gesamtquerschnittsfläche der Einzelfasern vor der Verschmelzung entspricht oder maximal 25% kleiner als diese ist.

16. Verfahren nach mindestens einem der Ansprüche 11 bis 15,
**dadurch gekennzeichnet, dass** für die Begrenzung des Verfahrweges der Heißpresse seitlich des Faserbündels zumindest ein Distanzstück (11) auf die Trägerplatte (2) aufgebracht wird, oder als Bestandteil von Träger- oder Deckplatte vorhanden ist.

17. Verfahren nach mindestens einem der Ansprüche 11 bis 16,
**dadurch gekennzeichnet, dass** das Heißpressverfahren mit einem Paar gegenüberliegender Pressstempel (15, 16) durchgeführt wird, welche einen Teilbereich aufweisen, in dem die Pressflächen eben und zueinander parallel sind, und einen sich anschließenden Teilbereich, in dem sich der Abstand der Pressflächen gleichmäßig vergrößert, wodurch die Ausdehnung der Übergangszone beeinflusst wird.

18. Verfahren nach mindestens einem der Ansprüche 11 bis 17,
**dadurch gekennzeichnet, dass** zur Vermeidung eines Anhaftens oder Anglasens der Trägerplatte und/oder der Deckplatte an den Pressstempeln ein Trennmittel (18) verwendet wird.

19. Verfahren nach mindestens einem der Ansprüche 11 bis 18,
**dadurch gekennzeichnet, dass** weitere Konfektionierungsschritte wie Maßnahmen zur Fixierung und Stabilisierung, z.B. Befüllen mit Klebstoff, sowie Endflächenbearbeitung, Stecker- und Schlauchmontage durchgeführt werden.

20. Verfahren nach mindestens einem der Ansprüche 11 bis 19,
**dadurch gekennzeichnet, dass** vor dem Heißpressverfahren eine Deckplatte (3) auf den optischen Fasern aufgebracht wird, welche sich im Heißpressverfahren in der Verschmelzzone (8) formschlüssig mit den optischen Fasern der obersten Lage der Fasern verbindet.

21. Verwendung eines Lichtleiters nach mindestens einem der Ansprüche 1 bis 10 zur Kopplung mit einem Laserdiodenbarren, bevorzugt einem Hochleistungslaserdiodenbarren.

## Claims

1. A light guide containing a plurality of optical fibres having an incoupling end (1) and one or more outcoupling ends, wherein the incoupling end (1) comprises a fusion zone (8), in which the fibres (4, 5) are connected together at least in part in a form-fitting manner,
a subsequent transition zone (9), in which the cross-section of the optical fibres (4, 5) passes from a substantially polygonal shape into a substantially circular shape, and
a subsequent outlet zone (10), in which the fibres (12, 13) have a substantially circular cross-sectional shape, **characterised in that**
the fibres are arranged in a monolayer or even in several layers on a carrier plate (2) and, in the region of the fusion zone (8), the fibres of the lowermost layer are connected with the carrier plate (2) in a form-fitting manner and **in that** the surface of the carrier plate (2) facing the fibres has an average roughness R_{z} < 1 µm, most preferably R_{z} < 0.2 µm.

2. The light guide according to claim 1,
**characterised in that** the optical fibres are step-index multimode glass fibres with a single fibre diameter D, and **in that** the ratio of the cladding thickness to the intended application wavelength is less than 5, most preferably between 0.5 and 3.

3. The light guide according to any one of claims 1 to 2,
**characterised in that** the linear thermal expansion of the carrier plate (2) in the temperature range 20°C to 300°C, is at most 3·10⁻⁶/K smaller than, but preferably greater than, that of the cladding glass of the optical fibres.

4. The light guide according to any one of claims 1 to 3,
**characterised in that** the fibres in the region of the outlet zone (10) and/or the transition zone (9) are fixed relatively to the carrier plate (2) using suitable means, preferably by an adhesive.

5. The light guide according to any one of claims 1 to 4,
**characterised in that** the carrier plate (2) is made from a type of glass having a softening temperature E_{W} which is greater than the highest E_{W} of the glasses used in the optical fibres, preferably at least 50 K greater than the highest softening temperature E_{W} of the glasses used in the optical fibres.

6. The light guide according to any one of claims 1 to 5,
**characterised in that** the optical fibres in the region of the transition zone (9) and fusion zone (8) are arranged in a single layer, parallel and flush and in the region of the fusion zone (8) have an almost rectangular cross section, are arranged in a form-fitting manner and jointly form a slit-shaped incoupling surface, having a height of between 60% and 90% of the fibre diameter D.

7. The light guide according to any one of claims 1 to 5,
**characterised in that**, in the transition region of the outlet zone and transition zone (9), the optical fibres are arranged in a single layer, parallel and at equal distances in parallel, wherein each two fibres have a distance of 0 to 5 times the fibre diameter D, and in the region of the fusion zone (8) are arranged in a form-fitting manner and jointly form a slit-shaped incoupling surface, having a height of between 15% and 90% of the fibre diameter D.

8. The light guide according to at least one of claims 1 to 5, **characterised in that** the optical fibres in the transition region from the outlet zone and transition zone are arranged in a single layer, in parallel and in groups of 1 to 5 fibres, and in the region of the fusion zone (8) each group of fibres is arranged in a form-fitting manner, wherein during later coupling of the incoupling surface of the light guide to a laser diode bar, an emitter is assigned to each group of fibres and wherein during later coupling of the incoupling surface of the light guide to a laser diode bar no fibres are arranged in the regions of the incoupling surface that are associated to the surface between two emitters.

9. The light guide according to any one of claims 1 to 7,
**characterised in that** the incoupling surface in the fusion zone (8) is filled with the optical fibres (4, 5) in a form-fitting manner and the sum of the cross-sectional areas of the individual fibres in the fusion zone (8) corresponds substantially to the sum of the cross-sectional areas of the individual fibres in the outlet zone (10) or is at most 25% less than this.

10. The light guide according to any one of claims 1 to 8,
**characterised in that** the fibres in the fusion zone (8) are connected on their upper side to a cover plate (3) in a form-fitting manner, wherein the surface of the cover plate (3) facing the fibres comprises an average roughness R_{z} < 1 µm, most preferably R_{z} < 0.2 µm, and the linear thermal expansion in the temperature range 20°C to 300°C of the cover plate is at most 3·10⁻⁶/K less than, but preferably greater than, that of the cladding glass of the optical fibres and wherein the cover plate (3) is made of a type of glass, having a softening temperature E_{W} greater than the highest E_{W} of glasses used in the optical fibres, preferably at least 50 K greater than the highest softening temperature E_{W} of the glasses used in the optical fibres.

11. A method for producing an optical incoupling end (1) of a light guide comprising a plurality of optical fibres with an essentially circular cross-section (12, 13) in the initial state,
**characterised in that**
the optical fibres are arranged and fixed in one or more layers on a carrier plate (2),
the fibres are then shaped in a hot-press process through the introduction of force and heat, at least in a subregion of the carrier plate (2), in such a way that the optical fibres connect together, at least in groups, in a form-fitting manner and connect the lowermost layer of the fibres to the carrier plate (2) in a form-fitting manner,
whereby a fusion zone (8) is produced, in which the fibres (4, 5) are connected together, at least in groups, in a form-fitting manner and the lowermost layer of the fibres is connected to the carrier plate in a form-fitting manner, a subsequent transition zone (9), in which the cross-sectional shape of the optical fibres passes from a substantially polygonal shape into a substantially circular shape and a subsequent outlet zone (10), in which the optical fibres have a substantially circular cross-sectional shape (12, 13) and wherein the surface of the carrier plate (2) facing the fibres has an average roughness R_{z} < 1 µm, most preferably R_{z} < 0.2 µm.

12. The method according to claim 11, **characterised in that** the optical fibres are step-index multimode glass fibres having a uniform fibre diameter D, and **in that** the ratio of the cladding thickness to the intended application wavelength is less than 5, most preferably between 0.5 and 3.

13. The method according to at least one of claims 11 to 12, **characterised in that** the fibres are arranged with an overhang on at least one side on the carrier plate (2) and, before the hot-pressing process, are temporarily or permanently fixed by suitable means, such as adhesive tape or an adhesive (17) for example, on at least one side in the region of this overhang.

14. The method according to at least one of claims 11 to 13, **characterised in that** the fibres are fixed on the carrier plate (2) before the hot-press process in one region, , which is not pressed in the hot-press process.

15. The method according to at least one of claims 11 to 14, **characterised in that** the fibres in the fusion zone (8) are pressed to the extent that the active cross-sectional area of the incoupling end at the fusion zone (8) is filled with optical fibres (4, 5) in a form-fitting manner and the total cross-sectional area of the individual fibres in the fusion zone corresponds substantially to the total cross-sectional area of the individual fibres before fused, or is that most 25% less than this.

16. The method according to any one of claims 11 to 15,
**characterized in that** for the limitation of the movement of the hot press aside of the fiber bundle at least one spacer (11) is applied to the carrier plate (2), or is present as a component of carrier or cover plate.

17. The method according to any one of claims 11 to 16,
**characterised in that** the hot-press process is carried out using a pair of opposed pressing dies (15, 16) having a subregion, in which the press surfaces are flat and parallel to one another, and having a subsequent subregion in which the spacing of the press surfaces increases uniformly, whereby the extension of the transition zone is influenced.

18. The method according to any one of claims 11 to 17,
**characterised in that** in order to avoid adhering, sticking or glazing of the carrier plate and/or the cover plate, a release agent (18) is used on the pressing dies.

19. The method according to any one of claims 11 to 18,
**characterised in that** further assembly steps are carried out, such as fixing and stabilising measures, for example filling with adhesive, as well as end surface processing, mounting of connectors and hoses.

20. The method according to any one of claims 11 to 19,
**characterised in that**, before the hot-press process, a cover plate (3) is applied on the optical fibres, which is connected in a form-fitting manner during the hot-press process to the optical fibres of the uppermost layer of the fibres in the fusion zone (8).

21. The use of a light guide according to at least one of claims 1 to 10 for coupling with a laser diode bar, preferably a high-power laser diode bar.

## Revendications

1. Guide d'ondes contenant une pluralité de fibres optiques avec une extrémité de couplage (1) et une ou plusieurs extrémités de découplage, l'extrémité de couplage (1) présentant
une zone de fusion (8), dans laquelle les fibres (4, 5) sont reliées les unes aux autres au moins partiellement par complémentarité de forme,
après celle-ci une zone de transition (9), dans laquelle la section transversale des fibres optiques (4, 5) subit une transition d'une forme essentiellement polygonale à une forme essentiellement circulaire et
après celle-ci une zone de dégagement (10), dans laquelle les fibres (12, 13) présentent une forme en section transversale essentiellement circulaire, **caractérisé en ce que**
les fibres sont disposées dans une monocouche ou également plusieurs couches sur une plaque de support (2) et les fibres de la couche la plus en dessous sont reliées, dans la région de la zone de fusion (8) par complémentarité de forme avec la plaque de support (2) et **en ce que** la surface de la plaque de support (2) orientée vers les fibres présente une rugosité moyenne R_{z} < 1 µm, préférablement R_{z} < 0,2 µm.

2. Guide d'ondes selon la revendication 1,
**caractérisé en ce que** les fibres optiques sont des fibres de verre multimode à saut d'indice avec un diamètre de fibre uniforme D et **en ce que** le rapport de l'épaisseur de gaine à la longueur d'ondes d'utilisation envisagée est inférieur à 5, préférablement compris entre 0,5 et 3.

3. Guide d'ondes selon au moins une des revendications 1 à 2,
**caractérisé en ce que** la dilatation thermique linéaire, dans la plage de température de 20°C à 300°C de la plaque de support (2) est au maximum 3·10⁻⁶/K inférieure, de préférence cependant supérieure à celle du verre de gainage des fibres optiques.

4. Guide d'ondes selon au moins une des revendications 1 à 3,
**caractérisé en ce que** les fibres dans la région de la zone de dégagement (10) et/ou de la zone de transition (9) sont fixées par un moyen adapté par rapport à la plaque de support (2), de préférence par le biais d'un adhésif.

5. Guide d'ondes selon au moins une des revendications 1 à 4,
**caractérisé en ce que** la plaque de support (2) est constituée d'un type de verre, dont la température de ramollissement E_{W} se trouve au-dessus de la température E_{W} la plus élevée des types de verre utilisés dans les fibres optiques, de préférence au moins 50 K supérieure à la température de ramollissement la plus élevée E_{W} des types de verre utilisés dans les fibres optiques.

6. Guide d'ondes selon au moins une des revendications 1 à 5,
**caractérisé en ce que** les fibres optiques, dans la région de la zone de transition (9) et de la zone de fusion (8), sont disposées en une seule couche, de manière parallèle et à fleur et, dans la région de la zone de fusion (8), présentent une section transversale approximativement rectangulaire, sont disposées par complémentarité de forme et forment ensemble une surface de couplage en forme de fente, dont la hauteur est comprise entre 60% et 90% du diamètre de fibres D.

7. Guide d'ondes selon au moins une des revendications 1 à 5,
**caractérisé en ce que** les fibres optiques, dans la région de transition entre la zone de dégagement et la zone de transition (9), sont disposées en une seule couche, parallèles et à intervalles parallèles réguliers, deux fibres présentant respectivement un intervalle de 0 à 5 fois le diamètre de fibre D et, dans la région de la zone de fusion (8), sont disposées par complémentarité de forme et forment ensemble une surface de couplage en forme de fente, dont la hauteur est comprise entre 15% et 90% du diamètre de fibre D.

8. Guide d'ondes selon au moins une des revendications 1 à 5, **caractérisé en ce que** les fibres optiques, dans la région de transition entre la zone de dégagement et la zone de transition, sont disposées en une seule couche, parallèles et en groupes de respectivement 1 à 5 fibres et, dans la région de la zone de fusion (8), les fibres sont disposées respectivement en un groupe par complémentarité de forme, lors du couplage ultérieur du guide d'ondes avec une barre de diodes laser, un groupe de fibres étant attribué respectivement à un émetteur et aucune fibre n'étant disposée dans les régions de la surface de couplage, qui, lors du couplage ultérieur du guide d'ondes avec une barre de diodes laser, sont attribuées à la surface entre deux émetteurs.

9. Guide d'ondes selon au moins une des revendications 1 à 7,
**caractérisé en ce que** la surface de couplage dans la zone de fusion (8) est remplie par complémentarité de forme avec les fibres optiques (4, 5) et la surface en section transversale totalisée des fibres individuelles dans la zone de fusion (8) correspond essentiellement à la surface en section transversale totalisée des fibres individuelles dans la zone de dégagement (10) ou est au maximum 25% inférieure à celle-ci.

10. Guide d'ondes selon au moins une des revendications 1 à 8,
**caractérisé en ce que** les fibres, dans la zone de fusion (8), sont reliées au niveau de leur côté supérieur avec une plaque de couverture (3) par complémentarité de forme, la surface de la plaque de couverture (3) orientée vers les fibres présentant une rugosité moyenne R_{z}< 1 µm, préférablement R_{z}< 0,2 µm et la dilatation thermique linéaire, dans la plage de température de 20°C à 300°C, de la plaque de couverture, étant au maximum inférieure de 3·10⁻⁶/K, de préférence cependant supérieure à celle du verre de gaine des fibres optiques et la plaque de couverture (3) étant d'un type de verre, dont la température de ramollissement E_{W} étant supérieure à la température E_{W} la plus élevée des types de verre utilisés dans les fibres optiques, de préférence au moins 50 K supérieure à la température de ramollissement E_{W} la plus élevée des types de verre utilisés dans les fibres optiques.

11. Procédé de fabrication d'une extrémité de couplage optique (1) d'un guide d'ondes comprenant une pluralité de fibres optiques avec une section transversale essentiellement circulaire (12, 13) dans l'état initial,
caractérisé en ce
les fibres optiques sont disposées et fixées en une ou plusieurs couches sur une plaque de support (2),
les fibres optiques sont ensuite déformées dans un procédé de pressage à chaud avec un apport de force et de chaleur, au moins dans une région partielle de la plaque de support (2), de sorte que les fibres optiques se lient les unes aux autres au moins par groupes par complémentarité de forme et que la couche de fibres la plus en dessous se lie par complémentarité de forme avec la plaque de support (2),
moyennant quoi une zone de fusion (8) est produite, dans laquelle les fibres sont reliées les unes aux autres au moins par groupes par complémentarité de forme (4, 5) et la couche de fibres la plus en dessous se lie par complémentarité de forme avec la plaque de support, une zone de transition (9) disposée après celle-ci, dans laquelle la forme en section transversale des fibres optiques effectue une transition d'une forme essentiellement rectangulaire à une forme essentiellement circulaire et une zone de dégagement (10) après celle-ci, dans laquelle les fibres optiques présentent une forme en section transversale essentiellement circulaire (12, 13) et la surface de la plaque de support (2) orientée vers les fibres présentant une rugosité moyenne R_{z} < 1 µm, préférablement R_{z} < 0,2 µm.

12. Procédé selon la revendication 11, **caractérisé en ce que** les fibres optiques sont des fibres de verre multimode à saut d'indice avec un diamètre de fibre uniforme D et **en ce que** le rapport de l'épaisseur de gaine à la longueur d'ondes d'utilisation envisagée est inférieur à 5, préférablement compris entre 0,5 et 3.

13. Procédé selon au moins une des revendications 11 à 12, **caractérisé en ce que** les fibres sont disposées sur la plaque de support (2) avec un surplomb au moins d'un côté et, avant le procédé de pressage à chaud, fixées de manière temporaire ou permanente au moins d'un côté dans la région de ce surplomb par un moyen adapté comme par exemple une bande adhésive ou un adhésif (17).

14. Procédé selon au moins une des revendications 11 à 13, **caractérisé en ce que** les fibres, avant le procédé de pressage à chaud, sont fixées sur la plaque de support (2) dans une région qui n'est pas pressées lors du procédé de pressage à chaud.

15. Procédé selon au moins une des revendications 11 à 14, **caractérisé en ce que** les fibres dans la zone de fusion (8) sont pressées de sorte que la surface en section transversale active de l'extrémité de couplage soit remplie, dans la zone de fusion (8) par complémentarité de forme, par les fibres optiques (4, 5) et la surface en section transversale totale des fibres individuelles dans la zone de fusion corresponde essentiellement à la surface en section transversale totale des fibres individuelles avant la fusion ou soit au maximum inférieure de 25% à celle-ci.

16. Procédé selon au moins une des revendications 11 à 15,
**caractérisé en ce que**, pour limiter le trajet de course de la presse à chaud latéralement par rapport au groupe de fibres, au moins une entretoise (11) est appliquée sur la plaque de support (2) ou est présente sous forme de constituant de la plaque de support ou de couverture.

17. Procédé selon au moins une des revendications 11 à 16,
**caractérisé en ce que** le procédé de pressage à chaud est réalisé avec une paire de pistons de presse (15, 16), qui présentent une région partielle, dans laquelle les surfaces de presse sont plates et parallèles les unes aux autres et une région partielle après celle-ci, dans laquelle l'intervalle entre les surfaces de presse s'agrandit de façon uniforme, moyennant quoi la dilatation de la zone de transition est influencée.

18. Procédé selon au moins une des revendications 11 à 17,
**caractérisé en ce que**, pour éviter une adhérence ou une vitrification de la plaque de support et/ou de la plaque de couverture sur les pistons de presse, un moyen de séparation (18) est utilisé.

19. Procédé selon au moins une des revendications 11 à 18,
**caractérisé en ce que** d'autres étapes de confection sont réalisées, telles que des mesures pour la fixation et la stabilisation, par exemple le remplissage par de l'adhésif, ainsi qu'un usinage des surfaces d'extrémité, un montage de connecteur et de tube.

20. Procédé selon au moins une des revendications 11 à 19,
**caractérisé en ce que**, avant le procédé de pressage à chaud, une plaque de couverture (3) est appliquée sur les fibres optiques, qui se lie, pendant le procédé de pressage à chaud, dans la zone de fusion (8), par complémentarité de forme, avec Is fibres optiques de la couche la plus au-dessus.

21. Utilisation d'un guide d'ondes selon au moins une des revendications 1 à 10 afin de la coupler à une barre de diodes laser, de préférence une barre de diodes laser haute performance.
